# EUROPÄISCHE PATENTSCHRIFT

(11) **EP 3 542 015 B1**
(45) Veröffentlichungstag und Bekanntmachung des Hinweises auf die Patenterteilung: **29.10.2025**
(21) Anmeldenummer: 17780096.8
(22) Anmeldetag: 05.10.2017
(51) Int. Cl.: E05B 81/76, H03K 17/97, H03K 17/96, G07C 9/00, G06F 3/041

(54) **SENSORSYSTEM ZUR AKTIVIERUNG WENIGSTENS EINER FAHRZEUGFUNKTION**
SENSOR SYSTEM FOR ACTIVATING AT LEAST ONE VEHICLE FUNCTION
SYSTÈME DE DÉTECTION DESTINÉ À L'ACTIVATION D'AU MOINS UNE FONCTION DE VÉHICULE

(30) Priorität: 16.11.2016 DE 102016122052; 22.11.2016 DE 102016122550
(43) Veröffentlichungstag der Anmeldung: 25.09.2019
(73) Patentinhaber: HUF Hülsbeck & Fürst GmbH & Co. KG, 42551 Velbert (DE)
(72) Erfinder: GORENZWEIG, Igor Alexander, 42109 Wuppertal (DE); LÖPKE, Christian, 42579 Heiligenhaus (DE); WITTE, Martin, 48683 Ahaus (DE)
(74) Vertreter: Bals & Vogel Patentanwälte PartGmbB
(86) Internationale Anmeldenummer: PCT/EP2017/075311
(87) Internationale Veröffentlichungsnummer: WO 2018/091199

(56) Entgegenhaltungen:
- EP-A1- 0 582 969
- EP-A1- 3 461 697
- EP-B1- 3 512 727
- DE-A1- 102006 012 336
- DE-A1- 102006 057 389
- DE-A1- 102015 100 074
- DE-T5- 112009 001 715
- US-A1- 2015 368 935

## Beschreibung

Die vorliegende Erfindung betrifft ein Sensorsystem zur Aktivierung wenigstens einer Fahrzeugfunktion eines Fahrzeuges gemäß der im Oberbegriff des Anspruchs 1 näher definierten Art. Ferner bezieht sich die Erfindung auf ein Sensormodul gemäß dem Oberbegriff des Anspruchs 8, ein Fahrzeug gemäß dem Oberbegriff des Anspruchs 10 sowie ein Verfahren zur Aktivierung wenigstens einer Fahrzeugfunktion eines Fahrzeuges.

Es ist aus dem Stand der Technik bekannt, z.B. aus EP 0 582 969 A oder DE 10 2006 012336 A1, dass tast- und/oder druckempfindliche Sensoren sowie Näherungssensoren bei Fahrzeugen vorgesehen sein können. Derartige Sensoren können bspw. bei einem Türgriff eingesetzt werden, um eine Berührung des Türgriffs zu detektieren. Dabei sind die meisten Drucksensoren von außen zugänglich, um eine erfolgreiche Messung zu realisieren. Als Reaktion auf eine Detektion durch den entsprechenden Sensor kann eine Fahrzeugfunktion aktiviert werden, bspw. ein Aktivieren eines elektronischen Schlosses. Somit kann intuitiv durch die Berührung des Türgriffs einer Tür bspw. das Öffnen der Tür ermöglicht werden. Häufig kommen hierzu kapazitive Sensoren zum Einsatz.

Nachteilhaft bei den bekannten Lösungen, insbesondere bei kapazitiven Sensoren, ist, dass die Auswertung der Erfassung der Sensoren aufwendig und technisch komplex ist. Insbesondere können Störeinflüsse, wie Umwelteinflüsse (z. B. Feuchtigkeit oder Regen) die Auswertung erschweren. Weiter sind häufig die Möglichkeiten zur Aktivierung der Fahrzeugfunktion durch herkömmliche Sensorsysteme noch eingeschränkt. Die tast- und/oder druckempfindlichen Sensoren durchbrechen in der Regel mit einer notwendigen Öffnung die jeweils angrenzende Außenfläche, damit ihr Messbereich direkt von außen zugänglich ist. Hierdurch entstehen zusätzliche Einbauschwierigkeiten, wie z. B. Abdichtung gegen Feuchtigkeit, mechanische Aufnahme der erforderlichen Druckkräfte auf den Sensor und dergleichen.

Es ist daher eine Aufgabe der vorliegenden Erfindung, die voranstehend beschriebenen Nachteile zumindest teilweise zu beheben. Insbesondere ist es eine Aufgabe der vorliegenden Erfindung, ein verbessertes Sensorsystem bereitzustellen, welches eine zuverlässigere und/oder komfortablere und/oder einfachere Möglichkeit zur Aktivierung von Fahrzeugfunktionen bietet. Insbesondere sollen der konstruktive und mechanische Aufwand beim Einsatz des verbesserten Sensorsystems am Fahrzeug gering gehalten werden.

Die voranstehende Aufgabe wird gelöst durch ein Sensorsystem mit den Merkmalen des Anspruchs 1, ein Sensormodul mit den Merkmalen des Anspruchs 8, ein Fahrzeug mit den Merkmalen des Anspruchs 10 sowie durch ein Verfahren mit den Merkmalen des unabhängigen Verfahrensanspruchs. Weitere Merkmale und Details der Erfindung ergeben sich aus den jeweiligen Unteransprüchen, der Beschreibung und den Zeichnungen. Dabei gelten Merkmale und Details, die im Zusammenhang mit dem erfindungsgemäßen Sensorsystem beschrieben sind, selbstverständlich auch im Zusammenhang mit dem erfindungsgemäßen Sensormodul, dem erfindungsgemäßen Fahrzeug sowie dem erfindungsgemäßen Verfahren, und jeweils umgekehrt, so dass bezüglich der Offenbarung zu den einzelnen Erfindungsaspekten stets wechselseitig Bezug genommen wird bzw. werden kann.

Die Aufgabe wird insbesondere gelöst durch ein Sensorsystem zur Aktivierung wenigstens einer Fahrzeugfunktion eines Fahrzeuges, vorzugsweise zur Aktivierung wenigstens eines elektrischen Schlosses des Fahrzeuges, zumindest aufweisend:
- wenigstens ein erstes und zweites (und insbesondere drittes und ggf. viertes oder mindestens ein weiteres) Sensorelement jeweils zur Erfassung einer Deformation in zumindest einem (oder einem jeweiligen) Deformationsbereich am Fahrzeug,
- wenigstens eine (insbesondere zumindest teilweise elektronische) Verarbeitungsvorrichtung zur Auswertung der jeweiligen Erfassung der Sensorelemente, insbesondere durch den Empfang und/oder die Verarbeitung von jeweiligen Erfassungssignalen der Sensorelemente.

Mit anderen Worten können wenigstens zwei oder mehr, insbesondere eine Vielzahl, von Sensorelementen, insbesondere am Fahrzeug, vorgesehen sein. Bspw. kann ein erstes Sensorelement zur Durchführung einer ersten Erfassung einer ersten Deformation in einem (ersten) Deformationsbereich am Fahrzeug vorgesehen sein. Des Weiteren können bspw. ein zweites Sensorelement zur Durchführung einer zweiten Erfassung einer zweiten Deformation im Deformationsbereich oder in einem zweiten Deformationsbereich am Fahrzeug, und/oder ein drittes Sensorelement zur Durchführung einer dritten Erfassung einer dritten Deformation im Deformationsbereich oder in einem dritten Deformationsbereich am Fahrzeug, und/oder ein viertes Sensorelement zur Durchführung einer vierten Erfassung einer vierten Deformation im Deformationsbereich oder in einem vierten Deformationsbereich am Fahrzeug vorgesehen sein. Insbesondere gilt gleiches analog für weitere (fünfte, sechste, siebte, usw.) Sensorelemente. Somit ist es durch die Erfindung möglich, das Sensorsystem bspw. ohne konstruktive Änderungen innenseitig an einem Fahrzeugblech, einer Platte oder einer Strukturfläche vom Fahrzeug anzuordnen, die somit gleichzeitig den Deformationsbereich bildet, und außenseitig (entgegengesetzte Seite der Fläche zum Sensorsystem) durch einen Benutzer bedienbar ist.

Hierbei ist vorgesehen, dass ein durch wenigstens einige der Sensorelemente erfasster Deformationsverlauf durch die Verarbeitungsvorrichtung auswertbar ist, sodass in Abhängigkeit von dem (erfassten) Deformationsverlauf und/oder der Auswertung der Verarbeitungsvorrichtung die wenigstens eine Fahrzeugfunktion aktivierbar ist. Bspw. kann durch die Auswertung ein bestimmter Deformationsverlauf detektiert werden, welcher sich von anderen Deformationsverläufen unterscheidet. So kann bspw. bei Detektion eines ersten Deformationsverlaufs eine erste Fahrzeugfunktion und bei Detektion eines zweiten Deformationsverlaufs eine zweite Fahrzeugfunktion aktiviert werden. Dies hat den Vorteil, dass eine sehr zuverlässige und komfortable Möglichkeit zur Aktivierung der Fahrzeugfunktion bereitgestellt wird.

Weiter kann es möglich sein, dass die Deformation (insbesondere als eine einzige Deformation) und/oder ein Deformationsverlauf durch mehrere Sensorelemente (bspw. gleichzeitig) erfasst wird, wobei vorzugsweise jeweilige Erfassungssignale von den Sensorelementen zur Auswertung und/oder Detektion der Deformation und/oder des Deformationsverlaufs und/oder einer Geste ausgewertet werden. Hierbei kann die Sicherheit erhöht werden, wenn bspw. mehrere Sensorelemente zur Detektion genutzt werden. Hierzu können die Erfassungssignale bspw. miteinander verglichen werden. Auch kann es möglich sein, dass zumindest einige der Sensorelemente auf einen gemeinsamen Deformationsbereich derart ausgerichtet sind, dass eine Deformation in dem Deformationsbereich redundant erfasst wird. So kann bevorzugt die Erfassung einer oder mehrerer Deformationen durch mehrere Sensorelemente redundant durchgeführt werden.

Der Deformationsverlauf kann bspw. durch eine (mechanische) Geste eines Benutzers des Fahrzeuges bewirkt werden, indem der Benutzer bspw. wenigstens ein Fahrzeugteil in den Deformationsbereichen in bestimmter Weise (bspw. mit einer bestimmten Reihenfolge, Geschwindigkeit, oder dergleichen) durch eine Krafteinwirkung verformt. Die Krafteinwirkung ist z. B. ein leichtes Berühren oder Eindrücken des Fahrzeugteils mit einem Finger. Bspw. können dabei die Sensorelemente derart empfindlich ausgestaltet sein, dass selbst kleinste Verformungen des Fahrzeugteils im Deformationsbereich anhand der Erfassung detektiert werden können. Dies kann die Zuverlässigkeit und/oder Auswertbarkeit der Erfassung, insbesondere im Vergleich mit kapazitiven Sensoren, drastisch verbessern.

Vorzugsweise werden dabei unter einem Deformationsverlauf ein (insbesondere zeitlicher) Verlauf und/oder Ablauf von Deformationen (ggf. nachfolgend auch als Aktivierung- oder Deformationsbewegung oder Aktivierungshandlungs- oder Deformationsabfolge bezeichnet) in den Deformationsbereichen verstanden. Dabei können anhand des Deformationsverlaufs insbesondere Deformationen in unterschiedlichen Deformationsbereichen unterschieden werden. Bspw. werden durch die Auswertung der Verarbeitungsvorrichtung Informationen über wenigstens eine der nachfolgenden Parameter bewertet und/oder ermittelt:
- Intensität der jeweiligen Deformation,
- Richtung der Deformationsabfolge,
- Geschwindigkeit der Deformationsabfolge,
- Geometrie der Deformationsabfolge.

Damit können eine Vielzahl unterschiedlicher Parameter bei der Auswertung herangezogen werden, sodass eine Vielzahl verschiedener Aktivierungsmuster detektiert werden können. Die Aktivierungsmuster können bspw. anhand verschiedener Vorgaben für den Deformationsverlauf und/oder für die genannten Parameter detektiert werden (wobei sich die Vorgaben für unterschiedliche Aktivierungsmuster voneinander unterscheiden). So können bspw. gleiche Deformationsabfolgen mit unterschiedlicher Geschwindigkeit als unterschiedliche Aktivierungsmuster anhand der Erfassung der Sensorelemente detektiert werden. Dies ermöglicht es, in Abhängigkeit von den detektierten Aktivierungsmustern, unterschiedliche Fahrzeugfunktionen zu aktivieren.

Es ist denkbar, dass sich der erste Deformationsbereich von dem zweiten Deformationsbereich zumindest teilweise unterscheidet, wobei vorzugsweise sich die Deformationsbereiche auch überlappen können. Alternativ oder zusätzlich können zumindest einige der Deformationsbereiche auch beabstandet angeordnet sein, bspw. mit einem Abstand im Bereich von 1 bis 10 cm, bevorzugt 3 bis 6 cm.

Des Weiteren kann es möglich sein, dass neben den Sensorelementen noch wenigstens eine Sensoreinheit vorgesehen ist, und/oder eine Erfassung der wenigstens einen Sensoreinheit durch die Verarbeitungsvorrichtung ausgewertet wird. Bspw. ist die wenigstens eine Sensoreinheit in Bezug auf den Sensortyp unterschiedlich zu den Sensorelementen ausgebildet, bspw. als kapazitiver Sensor. Insbesondere kann dabei wenigstens eine Erfassung der wenigstens einen Sensoreinheit mit der Erfassung der jeweiligen Sensorelemente verglichen werden, insbesondere durch die Verarbeitungsvorrichtung. So kann, bspw. anhand von Schwellenwerten oder dergleichen, z. B. eine Plausibilisierung der Erfassung der Sensorelemente erfolgen.

Es kann vorgesehen sein, dass zumindest durch die Auswertung der Verarbeitungsvorrichtung ein Detektionsergebnis bestimmt wird, wobei ggf. noch weitere Auswertungen und/oder Verarbeitungen zur Bestimmung des Detektionsergebnisses durchgeführt werden. Insbesondere ist es möglich, dass die Verarbeitungsvorrichtung das Detektionsergebnis und/oder Auswertungsergebnis als ein elektrisches Signal bereitstellt, welches einen bestimmten Deformationsverlauf und/oder ein Aktivierungsmuster indiziert. So kann das elektrische Signal bspw. lediglich eine binäre "1" repräsentieren, um eine positive Detektion eines bestimmten Deformationsverlaufs zu indizieren. Dieses Signal kann dann bspw. durch eine Fahrzeugelektronik ausgewertet werden, sodass in Abhängigkeit von dem Signal die Fahrzeugfunktion durch die Fahrzeugelektronik aktiviert werden kann.

Erfindungsgemäß sind das wenigstens erste und zweite Sensorelement (d. h. ggf. auch die weiteren Sensorelemente) jeweils zur Induktivitätsmessung ausgeführt, sodass ein Messergebnis der Induktivitätsmessung für die Deformation im (jeweiligen) Deformationsbereich, insbesondere die Deformation an einer Außenverkleidung des Fahrzeuges, spezifisch ist. Die jeweiligen Sensorelemente können z. B. ein (induktives) Spulenelement (bzw. eine induktive Spule) aufweisen, um eine Induktivität zu messen und/oder eine Induktivitätsveränderung zu erfassen. Diese Induktivität bzw. Induktivitätsveränderung kann dann spezifisch für die Deformation sein. Auf diese Weise kann sehr zuverlässig eine Deformation und/oder eine Druckausübung auf ein Fahrzeugteil im Deformationsbereich (als Aktivierungshandlung) detektiert werden. Bspw. können dann verschiedene Aktivierungshandlungen (bspw. eine Abfolge von Deformationen in verschiedenen Deformationsbereiche) gemeinsam ein Aktivierungsmuster bilden, sodass in Abhängigkeit von einem bestimmten Aktivierungsmuster eine diesem zugeordnete Fahrzeugfunktion aktiviert werden kann.

Insbesondere kann der Deformationsbereich sich zumindest teilweise an (zumindest) einem Fahrzeugteil erstrecken. Vorzugsweise ist das Fahrzeugteil dabei wenigstens teilweise als Teil der Außenverkleidung und/oder Karosserie des Fahrzeuges, bspw. auch oder nur außerhalb der Türgriffe des Fahrzeuges, ausgebildet. Bspw. erstreckt sich dabei wenigstens einer der Deformationsbereiche in einem Bereich eines Fahrzeugteils unterhalb oder benachbart zu wenigstens einem der Türgriffe des Fahrzeuges. Bspw. kann das Fahrzeug aber auch türgrifffrei (ohne Türgriffe) ausgeführt sein, und/oder es können die Deformationsbereiche die Türgriffe ersetzen.

Vorzugsweise kann das Fahrzeugteil dabei, insbesondere zumindest teilweise im Deformationsbereich oder benachbart zum Deformationsbereich, eine Kennzeichnung aufweisen. Bspw. kann diese Kennzeichnung dazu dienen, den Deformationsbereich als Aktivierungsbereich für einen Benutzer zu indizieren. Somit kann die Kennzeichnung bspw. von außen sichtbar am Fahrzeugteil vorgesehen sein. Alternativ oder zusätzlich kann die Kennzeichnung auch innenseitig am Fahrzeugteil (d. h. fahrzeuginnenraumzugewandt) vorgesehen sein, und damit von außerhalb des Fahrzeuges unsichtbar sein. Dies hat bspw. den Vorteil, dass bei einer Montage ein Monteur den Deformationsbereich identifizieren, und/oder das wenigstens eine Sensorelement in Abhängigkeit von der Kennzeichnung befestigen kann. Dies ermöglicht eine sichere und zuverlässige Montage des Sensorsystems, insbesondere weil die Erfassung der Sensorelemente von einem Aktivierungsmittel im Fahrzeugteil abhängig ist. In anderen Worten kann das Aktivierungsmittel außerhalb eines Sensormoduls im oder am Fahrzeugteil vorgesehen sein, sodass es bei der Montage auf die exakte Positionierung des Sensormoduls mit den Sensorelementen relativ zum Aktivierungsmittel im Deformationsbereich ankommt. Insbesondere kann eine Kennzeichnung des Deformationsbereichs auch als eine Farbkennzeichnung und/oder als Klebestreifen und/oder als ein umlaufender (insbesondere den Deformationsbereich umlaufenden) Absatz und/oder dergleichen ausgebildet sein.

Insbesondere ist es für die Erfassung der Sensorelemente vorgesehen und/oder vorausgesetzt, dass im Deformationsbereich wenigstens ein induktives, insbesondere metallisches, Element vorgesehen ist, bspw. ein Aktivierungsmittel. Das Aktivierungsmittel kann dabei bspw. eine Metallschicht sein, oder durch das Fahrzeugteil selbst gebildet sein. So kann z. B. ein Fahrzeugteil, welches überwiegend aus Kunststoff gebildet ist, üblicherweise keine signifikante Induktivitätsveränderung hervorrufen. Daher kann ggf. in einem solchen Fall ein Aktivierungsmittel im Deformationsbereich, insbesondere am oder im Fahrzeugteil, vorgesehen sein. Das Aktivierungsmittel kann dabei bspw. auch als ein Metallstreifen oder eine Chromschicht oder eine sonstige induktive, insbesondere metallische, Beschichtung ausgebildet sein. Weiter kann vorzugsweise das Aktivierungsmittel an der Innenseite (d. h. fahrzeuginnenraumzugewandt) oder an der Außenseite (fahrzeuginnenraumabgewandt bzw. fahrzeugaußenbereichszugewandt) des Fahrzeugteils angeordnet sein. Vorzugsweise kann das Aktivierungsmittel durch das Fahrzeugteil selbst gebildet sein, wenn dieses bspw. aus Blech gebildet ist (bspw. bei einer Karosserie als Fahrzeugteil).

Es ist denkbar, dass das wenigstens erste und zweite Sensorelement jeweils zur Induktivitätsmessung an einem jeweiligen induktiven Aktivierungsmittel ausgeführt sind, wobei insbesondere das Aktivierungsmittel im (jeweiligen) Deformationsbereich anordbar ist, sodass vorzugsweise die jeweilige Deformation anhand der Induktivitätsmessung erfassbar ist, um in Abhängigkeit von der Induktivitätsmessung die wenigstens eine Fahrzeugfunktion zu aktivieren. Bspw. kann dazu jedes der Aktivierungsmittel jeweils einem der Sensorelemente zugeordnet sein, und dazu bspw. relativ zum jeweilig zugeordneten Sensorelement in einem vorgegebenen Abstand angeordnet sein. Der Abstand (Fahrzeugteilabstand) muss dabei insbesondere derart gewählt werden, dass bei einer Bewegung des Aktivierungsmittels aufgrund einer Deformation es zu einer signifikanten und damit für das jeweilige Sensorelement erfassbaren Induktivitätsveränderung kommt. Die Induktivitätsveränderung wird dabei insbesondere auch dadurch hervorgerufen, dass sich der Fahrzeugteilabstand für das entsprechende Sensorelement zum Aktivierungsmittel bei der Deformation ändert.

Auch ist es optional denkbar, dass der wenigstens eine bzw. jeweilige Deformationsbereich jeweils einen Bereich eines (einzelnen oder jeweiligen) Fahrzeugteils, insbesondere einer Außenverkleidung des Fahrzeuges, umfasst, insbesondere außerhalb eines Türgriffs. Bspw. kann der Deformationsbereich unterhalb oder benachbart oder hinter einem zugeordneten Türgriff angeordnet sein. Dies hat den Vorteil, dass bei Durchführung einer bestimmten Aktivierungshandlung und/oder eines bestimmten Aktivierungsmusters am Deformationsbereich durch die Erfassung der Sensorelemente eine bestimmte Türgrifffunktion als Fahrzeugfunktion aktiviert werden kann, ohne dass der Türgriff selbst betätigt werden muss. Die Türgrifffunktion ist bspw. eine Aktivierung des elektrischen Schlosses zum Öffnen und/oder Freigeben der Tür mit dem Türgriff.

Erfindungsgemäß ist eine Geometrieanordnung von wenigstens drei der Sensorelemente vorgesehen, wobei wenigstens das erste Sensorelement mit wenigstens einem Sensorabstand beabstandet von dem zweiten Sensorelement und den weiteren Sensorelementen angeordnet ist, sodass der Deformationsverlauf in Abhängigkeit von der Geometrieanordnung erfassbar ist. Die Geometrieanordnung betrifft dabei insbesondere eine bestimmte (feste) geometrische Anordnung der Sensorelemente. Bspw. können die Sensorelemente gemäß der Geometrieanordnung in einem Kreis oder einer anderen geometrischen Form angeordnet sein. Bevorzugt kann somit ein Aktivierungsmuster detektiert werden, welches die geometrische Form aufweist, insbesondere eine kreisförmige Abfolge von Deformationen (d. h. ein Benutzer führt mehrere Deformationen am Fahrzeugteil durch, sodass die Deformationen gemeinsam die geometrische Form, insbesondere einen Kreis nachbilden). Dies hat den Vorteil, dass eine besonders komfortable Aktivierung der Fahrzeugfunktion ermöglicht wird.

Insbesondere kann es möglich sein, dass die Fahrzeugfunktionen wenigstens eine der nachfolgenden Funktionen umfassen:
- Eine Freigabe oder ein Öffnen wenigstens einer Tür des Fahrzeuges, insbesondere durch eine Aktivierung eines elektrischen Schlosses der Tür,
- Eine Ansteuerung einer Zentralverriegelung des Fahrzeuges,
- Eine Freigabe oder Öffnen wenigstens einer Heckklappe des Fahrzeuges, insbesondere durch eine Aktivierung eines elektrischen Schlosses der Tür,
- Ein Wecksignal für eine (zentrale) Fahrzeugverriegelung,
- Eine Initiierung eines Authentifizierungsvorgangs,
- Eine Freigabe oder Öffnen wenigstens einer Handschuhfachklappe des Fahrzeuges, insbesondere durch eine Aktivierung eines elektrischen Schlosses des Handschuhfachs,
- Eine Aktivierung einer Fahrzeugbeleuchtung,
- Eine Steuerung einer Bewegung des Fahrzeuges, bspw. einer Fahrtrichtung und/oder zur Initiierung eines Stoppens des Fahrzeuges, bspw. für eine Rangier- und/oder automatische Einparkfunktion des Fahrzeuges,
- Eine Durchführung eines Notstops bei dem Fahrzeug.

Bspw. können somit durch die Aktivierungshandlungen und/oder Aktivierungsmuster, insbesondere Geste, von außerhalb des Fahrzeuges verschiedene Funktionen intuitiv aktiviert werden. Dies ermöglicht bspw., sicher und zuverlässig eine Einparkfunktion von außerhalb des Fahrzeuges zu steuern und/oder zu beenden.

Das Fahrzeug ist bspw. als Kraftfahrzeug und/oder Personenkraftfahrzeug und/oder Elektrofahrzeug und/oder selbstfahrendes (autonomes) Fahrzeug ausgeführt.

Vorzugsweise kann vorgesehen sein, dass das wenigstens eine erste und zweite Sensorelement, und insbesondere weitere Sensorelemente, in einer Geometrieanordnung mit festen Sensorabständen zueinander angeordnet sind, und vorzugsweise fest miteinander über ein Gehäuse verbunden sind, und insbesondere zumindest teilweise gemäß einer geometrischen Form, insbesondere kreisförmig oder rechteckig oder polygonal oder reihenförmig oder rautenförmig oder trapezförmig oder quadratförmig oder ellipsenförmig oder rhombusförmig oder sternförmig oder kreuzförmig, angeordnet sind. Dies hat den Vorteil, dass Aktivierungsmuster (z. B. Gesten) erfasst oder detektiert werden können, welche dieser geometrischen Form entsprechen. Der Deformationsverlauf kann dabei bspw. die geometrische Form nachbilden, z. B. durch eine Abfolge von Deformationen in den (jeweiligen) Deformationsbereichen, um so eine bestimmte Fahrzeugfunktion zu aktivieren. Werden bspw. Deformationen in den Deformationsbereichen derart erzeugt, dass die zeitliche Abfolge der Deformationen die geometrische Form nachbildet, so kann ein bestimmtes Aktivierungsmuster gemäß dieser geometrischen Form detektiert werden. Alternativ oder zusätzlich können die Sensorelemente auch als Matrix angeordnet sein, sodass verschiedene Deformationsverläufe mit unterschiedlichen geometrischen Formen durchgeführt werden können. Auch kann es möglich sein, dass anhand der Erfassung der Sensorelemente, trotz der festen Geometrieanordnung, verschiedene Aktivierungsmuster (Gesten) mit verschiedenen geometrischen Formen detektiert werden können. Dies kann bspw. durch einen Vergleich der Erfassungssignale der jeweiligen Sensorelemente erfolgen.

Es ist dabei denkbar, dass wenigstens ein Sensorabstand zwischen den Sensorelementen an eine Geometrieanordnung angepasst ist, und bevorzugt ein Fahrzeugteilabstand der jeweiligen Sensorelemente zu einem Fahrzeugteil dem Fahrzeugteil derart angepasst ist, dass der Fahrzeugteilabstand für sämtliche Sensorelemente im Wesentlichen gleich ist.

Damit kann eine zuverlässige Erfassung gewährleistet werden. Insbesondere ist dabei der Fahrzeugteilabstand so angepasst, dass eine Induktivitätsmessung an einem Aktivierungsmittel am Fahrzeugteil möglich ist.

Ferner kann im Rahmen der Erfindung vorgesehen sein, dass die jeweiligen Sensorelemente mit einem jeweiligen Fahrzeugteilabstand beabstandet zu (jeweiligen) Deformationsbereichen, insbesondere einer fahrzeug(innenraum)seitigen Innenseite eines Fahrzeugteils, angeordnet sind, sodass die Deformation im (jeweiligen) Deformationsbereich und/oder der zeitliche Deformationsverlauf dieser Deformationen durch die Verarbeitungsvorrichtung auswertbar ist. Die Anordnung und/oder eine Befestigung am Fahrzeug erfolgt dabei bspw. durch wenigstens ein Haltemittel, insbesondere durch wenigstens ein Klebeband oder wenigstens ein Rastmittel oder wenigstens eine Schraube oder wenigstens eine Nietverbindung oder dergleichen. Die Anordnung und/oder Befestigung der Sensorelemente (insbesondere des Sensorsystems und/oder Sensormoduls) erfolgt dabei bspw. über eine Befestigungsstruktur eines Gehäuses, bspw. lösbar oder unlösbar, insbesondere im Bereich des Fahrzeugteils oder im Fahrzeugteil oder an dem Fahrzeugteil und/oder dem Fahrzeug. Insbesondere erfolgt dabei die Anordnung und/oder Befestigung auf einer Innenseite des Fahrzeugteils und/oder an oder in einem Blechrahmen des Fahrzeugteils. Bspw. ist das Sensormodul bei einer Montage (als ein Bauteil) an einem fahrzeuginnenraumseitigen Bereich des Fahrzeugteils, bspw. einem Blech oder dergleichen, befestigbar.

Außerdem kann es im Rahmen der Erfindung von Vorteil sein, dass die Sensorelemente jeweils als LDC-Sensorelement und/oder induktiver Sensor oder dergleichen, insbesondere als (LDC-) Spule, ausgeführt sind, sodass das Sensorsystem als ein LDC-Sensorsystem und/oder induktives Sensorsystem, insbesondere zur Induktivitätsmessung, ausgeführt ist. (Die Abkürzung LDC steht hierbei für "Inductance-To-Digital Converter bzw. Induktivität-Digital-Umsetzer). Das wenigstens eine Sensorelement dient dabei insbesondere zur (indirekten) Messung der Verformung und/oder einer Berührung am Fahrzeugteil im Deformationsbereich. Somit können zuverlässig die Deformationen erfasst werden.

Bevorzugt dient das wenigstens eine Sensorelement und/oder das Sensorsystem, insbesondere als ein LDC-Sensorsystem, zur Erfassung von zumindest einer Veränderung einer Induktivität, d. h. insbesondere zur Induktivitätsmessung. Hierzu sind normalerweise verschiedene Bauteile und/oder Schaltkreise notwendig, welche insbesondere bei dem LDC-Sensor auf einem Chip, bzw. in einem integrierten Schaltkreis vereint sind. Der LDC-Sensor und/oder das Sensorsystem ist bspw. dazu aufgeführt, gleichzeitig die Impedanz und die Resonanzfrequenz eines LC-Schwingkreises zu messen. Hierbei ist das Sensorsystem vorzugsweise unempfindlich gegenüber äußeren Einflüssen wie Feuchtigkeit oder Verunreinigung im Deformationsbereich. Folglich kann zuverlässig eine Fehldetektion durch Einflüsse wie Regen, welche zu Störungen bei bspw. kapazitiven Sensoren führen, vermieden werden. Eine Fehldetektion durch äußere Einflüsse, welche eine Kraftausübung auf das Fahrzeugteil bewirken, kann bspw. dadurch vermieden werden, dass ausschließlich ein Teilbereich des Fahrzeugteils den Deformationsbereich aufweist und/oder entsprechende Schwellenwerte genutzt werden, welche für die jeweilige Aktivierungshandlung spezifisch sind. Das LDC-Sensorsystem hat dabei weiterhin die Vorteile, dass es sehr empfindlich für Verformungen ist und damit zur Detektion der Aktivierungshandlung (d. h. der Deformation bzw. des Deformationsverlaufs) sehr schnell und zuverlässig dienen kann. Das Sensorsystem hat dabei z. B. eine Auflösung unter einem Mikrometer mit bspw. einer Bittiefe zur Quantisierung der gemessenen Induktivitätswerte von mindestens 16 Bit oder wenigstens 24 Bit.

Es kann optional möglich sein, dass wenigstens ein induktives Aktivierungsmittel an oder in einem Fahrzeugteil, insbesondere einer Außenverkleidung des Fahrzeuges, derart beabstandet zu den Sensorelementen befestigt und/oder integriert ist, dass in den Deformationsbereichen bzw. dem wenigstens einen Deformationsbereich anhand einer Induktivitätsmessung am wenigstens einen Aktivierungsmittel die jeweilige Deformation, insbesondere ein Deformationsverlauf, durch die Sensorelemente erfassbar ist. Insbesondere kann der Deformationsverlauf dadurch beeinflusst und/oder bewirkt werden, dass unterschiedliche Aktivierungsmittel zeitlich nacheinander (durch die Deformationen) bewegt werden, und somit insbesondere dieser Bewegungsverlauf bzw. diese Bewegungsreihenfolge (oder auch Aktivierungsreihenfolge der Aktivierungsmittel) eine geometrische Form nachbildet. Da diese Bewegungsreihenfolge dadurch bestimmt wird, in welcher Reihenfolge ein Benutzer die Deformationen in den Deformationsbereichen mit den Aktivierungsmitteln durchführt, können durch den Benutzer eine Vielzahl verschiedener Aktivierungsmuster, insbesondere Gesten, zur Aktivierung verschiedener Fahrzeugfunktionen durchgeführt werden.

Bspw. kann das Aktivierungsmuster bzw. die Geste auch dazu dienen, einen bestimmten Code einzugeben, sodass die Fahrzeugfunktion nur bei Übereinstimmung des Aktivierungsmusters bzw. der Geste mit einer Vorgabe aktiviert wird. Auf diese Weise kann bspw. ein Muster als "Passwort" für die Fahrzeugfunktion genutzt werden.

Ferner ist es optional vorgesehen, dass zur Erfassung, insbesondere als Induktivitätsmessung, jeweils ein Aktivierungsmittel in jedem der Deformationsbereiche vorgesehen ist, welches als induktives Element, insbesondere metallisches Element, ausgeführt ist, vorzugsweise als eine Metallfolie und/oder als eine metallische und/oder verchromte Oberfläche oder Beschichtung eines Fahrzeugteils, insbesondere einer fahrzeuginnenraumseitigen (und insbesondere sensorelementseitigen) Innenseite einer Außenverkleidung des Fahrzeuges. Insbesondere kann dabei das Aktivierungsmittel fahrzeug(innenraum)seitig am Fahrzeugteil angeordnet sein, und ggf. somit außerhalb des Sensorsystems vorgesehen sein. Bspw. ist das Sensorsystem dann an das Aktivierungsmittel angepasst und wird bspw. an das Fahrzeugteil mit dem Aktivierungsmittel bei einer Montage befestigt.

Es ist ferner denkbar, dass ein Fahrzeugteil, insbesondere eine Außenverkleidung des Fahrzeuges, im (jeweiligen) Deformationsbereich (zumindest überwiegend) elastisch verformbar ausgestaltet ist, sodass vorzugsweise Deformationsabfolgen in den Deformationsbereichen (als Deformationsverlauf) anhand der Erfassung der Sensorelemente, insbesondere einer (jeweiligen) Induktivitätsmessung, erfassbar sind.

Bspw. kann es vorgesehen sein, dass die Verarbeitungsvorrichtung mit den jeweiligen Sensorelementen elektrisch über Leiterbahnen einer Leiterplatte verbunden ist. Insbesondere können dabei wenigstens einige der Sensorelemente und/oder die Verarbeitungsvorrichtung an der Leiterplatte befestigt sein, bspw. gelötet oder als ein SMD (Surface-mounted device) Bauteil. Die Verarbeitungsvorrichtung und/oder eine damit verbundene Schnittstellenvorrichtung ist dabei bspw. als ein integrierter Schaltkreis, insbesondere als Prozessor und/oder Mikrocontroller, ausgeführt. Damit kann eine zuverlässige und schnelle Auswertung erfolgen.

Des Weiteren kann vorgesehen sein, dass ein Gehäuse vorgesehen ist, insbesondere zur zumindest teilweisen Aufnahme und/oder Anordnung der Sensorelemente und/oder der Verarbeitungsvorrichtung und/oder einer Leiterplatte, wobei vorzugsweise die Leiterplatte im Gehäuse umspritzt und/oder mit Vergussmasse vergossen ist, wobei bevorzugt das Gehäuse eine Befestigungsstruktur zur Befestigung des Sensorsystems und/oder der Sensorelemente und/oder des Sensormoduls am Fahrzeug, insbesondere an ein Fahrzeugteil des Fahrzeuges, aufweist. Die Befestigung des Sensorsystems kann vorzugsweise innenseitig an einer Außenverkleidung, einem Fahrzeugblech, einer Platte oder einer Strukturfläche vom Fahrzeug, welche das zuvor erwähnte Fahrzeugteil beispielhaft bilden, erfolgen. Folglich stellen die Fahrzeugteile gleichzeitig den Deformationsbereich dar und sind außenseitig (entgegengesetzte Seite der Fläche des Fahrzeugteils zum Sensorsystem) durch einen Benutzer bedienbar. Das Gehäuse und/oder die Befestigungsstruktur und/oder ein Abstandshalter können dabei bspw. aus Kunststoff, insbesondere als Spritzgussteil, ausgeführt sein. Die Befestigungsstruktur kann bspw. zur Aufnahme und/oder Anbringung von Haltemitteln ausgeführt sein, um eine zuverlässige Befestigung am Fahrzeug zu ermöglichen.

Vorteilhafterweise kann im Rahmen der Erfindung vorgesehen sein, dass ein Gehäuse vorgesehen ist, welches wenigstens einen Abstandshalter umfasst, sodass insbesondere bei einer Befestigung des Gehäuses am Fahrzeugteil die Sensorelemente jeweils beabstandet zu einem jeweiligen Aktivierungsmittel im Deformationsbereich angeordnet sind, sodass eine jeweilige Deformation im Deformationsbereich mit dem jeweiligen Aktivierungsmittel zu einer Relativbewegung des jeweiligen Aktivierungsmittels in Bezug zu dem jeweiligen beabstandet angeordneten Sensorelement führt. Insbesondere ist dabei der Abstandshalter derart am Gehäuse ausgebildet, vorzugsweise als Vorsprung oder dergleichen, dass ein vorgegebener Fahrzeugteilabstand (innerhalb eines Toleranzbereiches) zwischen den Sensorelementen und den jeweiligen Aktivierungsmitteln bei der Befestigung am Fahrzeug(teil) eingehalten wird. Damit kann eine zuverlässige Erfassung und einfache Montage gewährleistet sein. Insbesondere ist dabei ein Bereich am Fahrzeug und/oder Fahrzeugteil sichtbar gekennzeichnet, an welchem das Gehäuse mit der Befestigungsstruktur angeordnet wird, um so die Montage weiter zu vereinfachen. Bspw. kann dabei das Aktivierungsmittel auch zumindest teilweise die Wandung bzw. das Blech des Fahrzeugteils sein.

Gemäß einer vorteilhaften Weiterbildung der Erfindung kann vorgesehen sein, dass ein Gehäuse vorgesehen ist, welches durch Kleben und/oder Schrauben und/oder Clipsen und/oder Einrasten an einem Fahrzeugteil befestigt wird, insbesondere durch eine Befestigungsstruktur des Gehäuses. Dies ermöglicht eine einfache und sichere Montage.

Weiter ist im Rahmen der Erfindung denkbar, dass die Sensorelemente jeweils wenigstens eine elektrische Spule, insbesondere LDC-Spule, zum Erzeugen und/oder Detektieren von einem Magnetfeld aufweisen. Insbesondere kann damit eine Induktivitätsveränderung detektiert werden. Insbesondere erfolgt dann eine Detektion einer Deformation in einem bestimmten Deformationsbereich, wenn die Werte eines Erfassungssignals des dem Deformationsbereich zugeordneten Sensorelements einen bestimmten Schwellenwert übersteigen. Dies hat den Vorteil, dass die verschiedenen Deformationen in den verschiedenen Deformationsbereichen in einfacher Weise zur Bestimmung des Deformationsverlaufs dienen können.

Es kann im Rahmen der Erfindung vorgesehen sein, dass eine Schnittstellenvorrichtung vorgesehen ist, um ein Ergebnis der Auswertung des Deformationsverlaufs an eine, insbesondere zentrale, Fahrzeugelektronik zu übertragen, wobei bevorzugt die Schnittstellenvorrichtung zur Verbindung mit einem Bussystem des Fahrzeuges ausgeführt ist, besonders bevorzugt mit einem LIN- (Local Interconnect Network-) oder CAN- (Controller Area Network-) Bus oder einer Trägerfrequenzanlage oder Powerline oder Patternsystem oder Open Collector. Die Trägerfrequenzanlage ist dabei insbesondere ein Datenübertragungssystem, welches ein vorhandenes Stromnetz des Fahrzeuges zur Datenübertragung nutzt. Damit kann eine besonders platzsparende Datenübertragung ermöglicht werden.

Bevorzugt kann es möglich sein, dass die Sensorelemente derart miteinander verbunden sind, dass das Sensormodul und/oder Sensorsystem einen Reihensensor (bzw. ein Sensorarray) bildet. Entsprechend können die Sensorelemente bspw. in Reihe angeordnet und/oder fest miteinander verbunden sein.

Ferner kann es im Rahmen der Erfindung vorgesehen sein, dass das Sensorsystem über eine Schnittstellenvorrichtung mit einem Übertragungssystem, insbesondere Trägerfrequenzanlage, verbindbar ist, sodass sowohl eine Energieversorgung für das Sensorsystem als auch eine Datenverbindung und/oder Datenübertragung, insbesondere zwischen der Verarbeitungsvorrichtung und einer Fahrzeugelektronik, über das Übertragungssystem, insbesondere über identische elektrische Leiter, bereitgestellt ist. Dies ermöglicht eine Reduzierung von Bauraum, welcher ansonsten für ein dediziertes Bussystem benötigt werden würde.

In einer weiteren Möglichkeit kann vorgesehen sein, dass das Aktivierungsmittel als eine elektrisch leitende Folie und/oder eine elektrisch leitende Beschichtung und/oder wenigstens ein elektrisch leitendes Element, insbesondere aus Metall, bevorzugt elastisch verformbar und/oder vollständig galvanisch getrennt, insbesondere von den Sensorelementen galvanisch getrennt, ausgestaltet ist, und besonders bevorzugt (insbesondere innenseitig) am Fahrzeugteil und/oder an einer Strukturanpassung an dem Fahrzeugteil angeordnet ist. Damit wird der Vorteil erzielt, dass eine geringfügige und kostengünstige Anpassung des Fahrzeugteils zur Detektion einer Induktivitätsveränderung ausreichend ist.

Bevorzugt kann es dabei möglich sein, dass eine Strukturanpassung im Deformationsbereich vorgesehen ist, welche bspw. als eine Ausnehmung oder Materialschwächung und/oder verringerte Wandstärke des Fahrzeugteils ausgebildet ist, sodass vorzugsweise bei einer Kraftausübung am Deformationsbereich (ausgehend von dem Außenbereich des Fahrzeuges) eine Relativbewegung des Aktivierungsmittels in Bezug auf wenigstens dem diesem zugeordneten Sensorelement erfolgt. Vorzugsweise weist das Fahrzeugteil dabei im Bereich der Strukturanpassung und/oder im Deformationsbereich eine ausreichende Verformbarkeit und/oder Elastizität auf, sodass die Relativbewegung möglich ist. Die Deformationen sind weiter bevorzugt elastische Verformungen.

Vorteilhaft ist es darüber hinaus, wenn im Rahmen der Erfindung ein Bereich zwischen den jeweiligen Sensorelementen und/oder wenigstens einen jeweils zugeordneten Aktivierungsmittel zumindest teilweise mit einem Füllelement, insbesondere Vergussmasse, ausgefüllt ist. Dies ermöglicht eine störungssichere Detektion, insbesondere durch einen Schutz vor äußeren Einflüssen, bspw. eindringende Feuchtigkeit.

Ebenfalls Gegenstand der Erfindung ist ein Sensormodul zur Aktivierung wenigstens einer Fahrzeugfunktion eines Fahrzeuges, vorzugsweise zur Aktivierung wenigstens eines elektrischen Schlosses des Fahrzeuges, mit wenigstens einem ersten und wenigstens einem zweiten Sensorelement, und mit einem Gehäuse, welches wenigstens eine Befestigungsstruktur aufweist.

Hierbei ist vorgesehen, dass die Sensorelemente über die Befestigungsstruktur des Gehäuses miteinander fest verbunden sind, sodass die Sensorelemente eine Geometrieanordnung bilden, wobei das Sensormodul durch die Befestigungsstruktur derart an ein Fahrzeugteil des Fahrzeuges befestigbar ist, dass die Geometrieanordnung mit wenigstens einem Deformationsbereich am Fahrzeugteil korrespondiert. Damit bringt das erfindungsgemäße Sensormodul die gleichen Vorteile mit sich, wie sie ausführlich mit Bezug auf ein erfindungsgemäßes Sensorsystem beschrieben worden sind. Zudem kann vorzugsweise das erfindungsgemäße Sensormodul gemäß einem erfindungsgemäßen Sensorsystem ausgestaltet sein.

Erfindungsgemäß sind das wenigstens erste und zweite Sensorelement jeweils zur Induktivitätsmessung ausgeführt, sodass ein Messergebnis der Induktivitätsmessung für die Deformation in einem jeweiligen Deformationsbereich an einer Außenverkleidung des Fahrzeuges, spezifisch ist. Eine Geometrieanordnung von wenigstens drei der Sensorelemente ist vorgesehen, wobei wenigstens das erste Sensorelement mit mindestens einem Sensorabstand beabstandet von dem zweiten Sensorelement und den weiteren Sensorelementen angeordnet ist, sodass der Deformationsverlauf in Abhängigkeit von der Geometrieanordnung erfassbar ist.

Es kann ferner möglich sein, dass das Sensormodul als ein einzeln handhabbares Modul ausgeführt ist, vorzugsweise zur Befestigung an einer Innenseite des Fahrzeugteils, vorzugsweise einer (fahrzeuginnenraumseitigen Innenseite einer) Außenverkleidung und/oder eines Türgriffs des Fahrzeuges.

Ebenfalls Gegenstand der Erfindung ist ein Fahrzeug, mit wenigstens einem erfindungsgemäßen Sensorsystem und/oder mit wenigstens einem erfindungsgemäßen Sensormodul. Hierbei ist vorgesehen, dass ein erstes Sensorsystem und/oder erstes Sensormodul an einem ersten Bereich des Fahrzeuges, insbesondere in einem Heckbereich des Fahrzeuges, angeordnet ist, und ein zweites Sensorsystem und/oder zweites Sensormodul an einem zweiten Bereich des Fahrzeuges, insbesondere in einem Seitenbereich des Fahrzeuges, angeordnet ist, sodass Deformationsverläufe an den unterschiedlichen Bereichen des Fahrzeuges erfassbar sind, um insbesondere jeweils unterschiedliche Fahrzeugfunktionen zu aktivieren. Damit bringt das erfindungsgemäße Fahrzeug die gleichen Vorteile mit sich, wie sie ausführlich mit Bezug auf ein erfindungsgemäßes Sensorsystem und/oder erfindungsgemäßes Sensormodul beschrieben worden sind.

Ein weiterer Vorteil kann im Rahmen der Erfindung erzielt werden, wenn die unterschiedlichen Fahrzeugfunktionen jeweils eine Aktivierung wenigstens eines elektrischen Schlosses umfassen, insbesondere zum Freigeben und/oder Öffnen von beweglichen Teilen des Fahrzeuges mit den jeweiligen Fahrzeugteilen. Bspw. können die verschiedenen Sensorsysteme und/oder Sensormodule auch zur Aktivierung von unterschiedlichen elektrischen Schlössern dienen, bspw. im Heck- und/oder Seitenbereich des Fahrzeuges. Ebenfalls Gegenstand der Erfindung ist ein Verfahren zur Aktivierung wenigstens einer Fahrzeugfunktion eines Fahrzeuges, vorzugsweise zur Aktivierung wenigstens eines elektrischen Schlosses des Fahrzeuges, mit wenigstens einem ersten und wenigstens einem zweiten Sensorelement.

Hierbei werden die nachfolgende Schritte durchgeführt:
a) Durchführen einer ersten Erfassung durch das erste Sensorelement, wobei die erste Erfassung für eine erste Deformation in einem ersten Deformationsbereich am Fahrzeug spezifisch ist,
b) Durchführen wenigstens einer zweiten Erfassung durch das wenigstens zweite Sensorelement, wobei die wenigstens zweite Erfassung für wenigstens eine zweite Deformation in wenigstens einem zweiten Deformationsbereich am Fahrzeug spezifisch ist,
c) Auswerten der ersten und der wenigstens zweiten Erfassung, sodass wenigstens ein Deformationsverlauf bestimmt wird,
d) Aktivieren der wenigstens einen Fahrzeugfunktion anhand des bestimmten Deformationsverlaufs.

Erfindungsgemäß sind das wenigstens erste und zweite Sensorelement jeweils zur Induktivitätsmessung ausgeführt, sodass ein Messergebnis der Induktivitätsmessung für die Deformation in einem jeweiligen Deformationsbereich an einer Außenverkleidung des Fahrzeuges, spezifisch ist. Eine Geometrieanordnung von wenigstens drei der Sensorelemente ist vorgesehen, wobei wenigstens das erste Sensorelement mit mindestens einem Sensorabstand beabstandet von dem zweiten Sensorelement und den weiteren Sensorelementen angeordnet ist, sodass der Deformationsverlauf in Abhängigkeit von der Geometrieanordnung erfassbar ist.

Damit bringt das erfindungsgemäße Verfahren die gleichen Vorteile mit sich, wie sie ausführlich mit Bezug auf ein erfindungsgemäßes Sensorsystem und/oder erfindungsgemäßes Sensormodul und/oder erfindungsgemäßes Fahrzeug beschrieben worden sind. Zudem kann das Verfahren geeignet sein, ein erfindungsgemäßes Sensorsystem und/oder erfindungsgemäßes Sensormodul und/oder erfindungsgemäßes Fahrzeug zu betreiben.

Es ist ferner denkbar, dass nach Schritt c) und/oder vor Schritt d) ein weiterer Schritt c') vorgesehen ist, wobei gemäß diesem weiteren Schritt c') wenigstens ein Erfassungssignal der jeweiligen (ersten und wenigstens zweiten) Erfassung ausgewertet wird. Insbesondere dienen die jeweiligen Sensorelemente zur Induktivitätsmessung, sodass die Erfassungssignale für Messwerte der Induktivitätsmessung spezifisch sind. Bevorzugt können diese Messwerte dann mit (jeweils) wenigstens einem vordefinierten Soll-Wert verglichen werden (bspw. einer Soll-Kraft). Bspw. werden die Spitzenwerte der Erfassungssignale ermittelt, um eine Krafteinwirkung durch die Deformation zu ermitteln und/oder mit dem Soll-Wert zu vergleichen.

Weiter kann es möglich sein, dass das Auswerten der ersten und/oder der wenigstens zweiten Erfassung derart erfolgt, dass wenigstens ein Krafteinfluss (z. B. quantitativ) bestimmt, d. h. insbesondere gemessen, wird, welcher mit wenigstens einer der jeweiligen Deformationen korreliert ist, sodass vorzugsweise das Aktivieren der wenigstens einen Fahrzeugfunktion anhand des bestimmten Krafteinflusses erfolgt. Bspw. ist ein jeweiliger bestimmter Krafteinfluss dadurch mit der jeweiligen Deformation korreliert, dass der bestimmte Krafteinfluss (gemäß einer Vorgabe) zur Durchführung der Deformation als notwendig angesehen wird. Die Vorgabe ist dabei bspw. eine vorgespeicherte Information zur Parametrisierung der Kraftmessung.

Insbesondere kann es möglich sein, dass bei der Auswertung gemäß Schritt c) eine Analyse der jeweiligen Erfassungen erfolgt, sodass anhand der Analyse eine jeweilige Krafteinwirkung (durch die jeweilige Deformation) ausgewertet werden kann. Hierzu werden bspw. Spitzenwerte der jeweiligen Erfassung bestimmt und/oder mit wenigstens einer Vorgabe verglichen. Die Vorgabe umfasst dabei bspw. vordefinierte Soll-Werte für die Krafteinwirkung. Bspw. kann auch die Krafteinwirkung durch die jeweilige Deformation quantitativ bestimmt werden. Weiter kann insbesondere die Aktivierung der wenigstens einen Fahrzeugfunktion in Abhängigkeit von einem Ergebnis der Analyse und/oder der bestimmten Krafteinwirkung erfolgen.

Bevorzugt ist die Erfassung eine Induktivitätsmessung, insbesondere an einem induktiven Aktivierungsmittel (im Deformationsbereich). Besonders bevorzugt dient die Erfassung dazu, eine kleinste Verformung im Deformationsbereich, insbesondere des Fahrzeugteils, vorzugsweise eines Blechs bzw. einer Außenverkleidung, zu detektieren. Die Deformation ist insbesondere ein leichter Druck mit einem Finger auf die Außenseite des Fahrzeugteils, bspw. durch einen Benutzer.

Es kann im Rahmen der Erfindung vorgesehen sein, dass die Auswertung gemäß Schritt c) einen Vergleich der ersten mit der wenigstens zweiten Erfassung umfasst, sodass der Deformationsverlauf für eine Geste eines Benutzers des Fahrzeuges spezifisch ist. Dies ermöglicht eine zuverlässige und komfortable Ansteuerung von Fahrzeugfunktionen.

Von weiterem Vorteil kann vorgesehen sein, dass bei Schritt c) ein erster Deformationsverlauf von einem zweiten Deformationsverlauf unterschieden wird, wobei gemäß Schritt d) eine erste Fahrzeugfunktion aktiviert wird, wenn der erste Deformationsverlauf bestimmt wird, und eine zweite Fahrzeugfunktion aktiviert wird, wenn der zweite Deformationsverlauf bestimmt wird. Gleiches kann für weitere Fahrzeugfunktionen und Deformationsverläufe gelten, um eine Vielzahl von Fahrzeugfunktionen ansteuern zu können.

Vorteilhaft ist es zudem, wenn gemäß Schritt c) zur Bestimmung des Deformationsverlaufs wenigstens ein erstes Erfassungssignal und wenigstens ein zweites Erfassungssignal, und vorzugsweise wenigstens ein drittes und viertes Erfassungssignal, von jeweils unterschiedlichen Sensorelementen miteinander verglichen werden, wobei vorzugsweise die Erfassungssignale jeweils zeitabhängig sind bzw. eine zeitabhängige Information umfassen, sodass insbesondere durch das Auswerten ein zeitliches Deformationsmuster bestimmt wird.

Insbesondere kann es dabei möglich sein, dass die Erfassungssignale jeweils bei einer Deformation im jeweiligen Deformationsbereich ein charakteristisches Muster aufweisen. Das Muster kann bspw. ein Übersteigen eines Schwellenwertes durch wenigstens einen Erfassungswert des entsprechenden Erfassungssignals sein. Somit kann durch eine Auswertung des Auftretens dieser Muster eine zeitliche Abfolge der Deformationen sowie eine Zuordnung der Deformationen zu den jeweiligen Sensorelementen erfolgen, um so insbesondere ein bestimmtes Aktivierungsmuster zu ermitteln.

Des Weiteren ist es im Rahmen der Erfindung optional möglich, dass bei den jeweiligen Sensorelementen zur Bestimmung einer jeweiligen Deformation und/oder des Deformationsverlaufs eine Abstandsveränderung zwischen wenigstens einem induktiven Aktivierungsmittel und dem jeweiligen Sensorelement ausgewertet wird. Bspw. wird dann eine Deformation detektiert, wenn eine Mindestabstandsveränderung vorliegt. Die Mindestabstandsveränderung liegt bspw. in einem Bereich zwischen 0,1 bis 10 mm, vorzugsweise 0,5 bis 8 mm, bevorzugt 1 bis 6 mm. Somit kann auch ein Schwellenwert festgelegt sein, um die Zuverlässigkeit bei der Detektion weiter zu erhöhen. In Abhängigkeit von detektierten Deformationen kann dann bspw. gemäß Schritt c) ein Deformationsverlauf bestimmt werden.

Vorzugsweise kann vorgesehen sein, dass der Deformationsverlauf für eine mechanische Geste an einem Fahrzeugteil spezifisch ist, wobei insbesondere die mechanische Geste zur elastischen Verformung des Fahrzeugteils und/oder Bewegung wenigstens eines Aktivierungsmittels relativ zu wenigstens einem der Sensorelemente führt. Die mechanische Geste ist damit bspw. eine Verformungsgeste am Fahrzeugteil. Die Verformung (bzw. Deformation) kann dabei elastisch sein und/oder kann derart geringfügig sein, dass diese von außen durch den Benutzer nicht oder kaum wahrnehmbar bzw. sichtbar ist.

Ferner kann im Rahmen der Erfindung vorgesehen sein, dass bei Schritt c) eine erste Deformation in einem ersten Deformationsbereich als eine erste Aktivierungshandlung von einer zweiten Deformation in einem zweiten Deformationsbereich als eine zweite Aktivierungshandlung unterschieden wird, wobei der Deformationsverlauf für eine Abfolge der Aktivierungshandlungen und/oder für eine Aktivierungsbewegung spezifisch ist, sodass unterschiedliche aufeinanderfolgende Aktivierungshandlungen (und/oder Aktivierungsbewegungen) jeweils unterschiedliche Gesten bilden, um eine der jeweiligen Geste zugeordnete Fahrzeugfunktion bei Schritt d) anhand des Deformationsverlaufs zu aktivieren. Insbesondere können die aufeinanderfolgenden Aktivierungshandlungen auch ein Entlangstreichen am Deformationsbereich (durch einen Benutzer) umfassen, z. B. von links nach rechts oder von rechts nach links oder dergleichen. Bspw. entspricht der Deformationsverlauf einer Erfassungsabfolge (d. h. es wird z. B. zeitlich zuerst anhand der zweiten Erfassung eine Verformung, und dann anhand der ersten Erfassung eine Verformung festgestellt). Weiter können ggf. unterschiedliche Erfassungsabfolgen unterschiedliche Gesten indizieren.

Zudem ist im Rahmen der Erfindung denkbar, dass bei Schritt c) anhand der Erfassungen und/oder des Deformationsverlaufs eine Geschwindigkeit einer Durchführung und/oder Abfolge von Aktivierungshandlungen bestimmt wird, wobei vorzugsweise die Aktivierungshandlungen jeweils wenigstens eine Deformation in wenigstens einem der Deformationsbereiche umfassen. Bspw. kann ein bestimmtes Aktivierungsmuster (d. h. auch eine Geste) auch dadurch gekennzeichnet sein, dass eine bestimmte Geschwindigkeit bei der Durchführung der Deformationen vorliegt. Insbesondere ist dabei eine Frequenz der positiven Erfassungen der Deformationen bei den Sensorelementen spezifisch für diese Geschwindigkeit und wird bspw. bei Schritt c) ausgewertet.

Es kann optional möglich sein, dass (vorzugsweise gemäß Schritt c) ) eine Aktivierungsbewegung und/oder Abfolge von Aktivierungshandlungen (insbesondere ein Aktivierungsmuster) in eine erste Richtung von einer Aktivierungsbewegung und/oder Abfolge von Aktivierungshandlungen (insbesondere einem Aktivierungsmuster) in eine zweite Richtung, insbesondere anhand der Auswertung, unterschieden wird, wobei vorzugsweise eine kreisförmige von einer linearen Aktivierungsbewegung und/oder Abfolge unterschieden wird, um jeweils zugeordnete unterschiedliche Fahrzeugfunktionen zu aktivieren. Insbesondere ist es dabei möglich, dass die Aktivierungshandlungen und/oder die Aktivierungsbewegungen jeweils wenigstens eine Deformation in wenigstens einem der Deformationsbereiche umfassen. Bspw. kann durch einen Vergleich einer vorgespeicherten Information über eine Geometrieanordnung der Sensorelemente mit einer Erfassungsreihenfolge der Sensorelemente (d. h. anhand einer Reihenfolge der Erfassungen der Deformationen durch die Sensorelemente) ein bestimmtes Aktivierungsmuster detektiert werden.

Nach einer weiteren Möglichkeit kann vorgesehen sein, dass zumindest das Auswerten gemäß Schritt c) durch eine Verarbeitungsvorrichtung durchgeführt wird, wobei durch die Verarbeitungsvorrichtung ein Auswertungsergebnis der Auswertung gemäß Schritt c) einer Fahrzeugelektronik, insbesondere über eine elektrische Schnittstelle und/oder Schnittstellenvorrichtung, bereitgestellt wird, wobei vorzugsweise das Auswertungsergebnis die zu aktivierende Fahrzeugfunktion indiziert. Das Auswertungsergebnis kann dabei bspw. ein Ergebnis einer Auswertung von Erfassungssignalen der jeweiligen Sensorelemente umfassen. Mit anderen Worten kann es möglich sein, dass nicht (nur oder garnicht) das "reine" Erfassungssignal der Sensorelemente durch die Schnittstelle bzw. die Schnittstellenvorrichtung bereitgestellt wird, sondern bereits ein Ergebnis der Auswertung dieser Erfassungssignale insbesondere unter Berücksichtigung einer zu detektierenden Geste bzw. eines Deformationsverlaufs. Bspw. umfasst dabei das Auswertungsergebnis Informationen über den Deformationsverlauf oder über ein detektiertes Aktivierungsmuster (bzw. eine Geste). Hierzu kann die Verarbeitungsvorrichtung bspw. auch mit einem nichtflüchtigen Datenspeicher verbunden sein, in welchen für die Verarbeitungsvorrichtung lesbare Informationen über Vorgaben für die möglichen Aktivierungsmuster bzw. Gesten gespeichert sind (bspw. auch Informationen über eine Geometrieanordnung der Sensorelemente). Bspw. kann das Auswertungsergebnis auch einfach nur angeben, ob ein bestimmtes Aktivierungsmuster bzw. eine bestimmte Geste detektiert wurde oder nicht. Somit kann die für die Auswertung erforderliche Logik bereit im Sensormodul bzw. Sensorsystem integriert sein. Eine Anpassungsfähigkeit für verschiedene Fahrzeuge ist damit gewährleistet.

Ferner kann im Rahmen der Erfindung vorgesehen sein, dass zumindest das Auswerten gemäß Schritt c) durch eine Verarbeitungsvorrichtung durchgeführt wird, wobei vorzugsweise die Verarbeitungsvorrichtung gemäß einem erfindungsgemäßen Sensorsystem ausgeführt ist.

Weiter ist es denkbar, dass die Verformung bzw. Deformation (d. h. ein Eindrücken in das Fahrzeugteil) eine Bewegung des Aktivierungsmittels in eine erste Richtung bewirkt.

Insbesondere ist der Deformationsverlauf und/oder sind die Erfassungen der Sensorelemente abhängig von einer Position der Verformung, wobei die Position bei Durchführung der Geste in einer Richtung orthogonal zur ersten Richtung variiert. Bspw. bewirkt dabei die Bewegung des Aktivierungsmittels eine Relativbewegung des Aktivierungsmittels zu wenigstens einem der Sensorelemente. Insbesondere können dabei je Sensorelement und Deformationsbereich mindestens ein Aktivierungsmittel vorgesehen sein, sodass eine Relativbewegung eines ersten Aktivierungsmittels zu einem ersten Sensorelement für einen ersten Deformationsbereich sich auf die erste Erfassung auswirkt, und eine Relativbewegung eines zweiten Aktivierungsmittels zu einem zweiten Sensorelement für einen zweiten Deformationsbereich sich auf die zweite Erfassung auswirkt. Insbesondere sind die den jeweiligen Sensorelementen und/oder Deformationsbereichen zugeordneten Aktivierungsmittel näher am jeweiligen Sensorelement und/oder Deformationsbereich angeordnet, als alle anderen Aktivierungsmittel für andere Sensorelemente und/oder Deformationsbereiche.

Weiter ist es denkbar, dass mit einer Schnittstellenvorrichtung wenigstens ein Anschlusselement verbunden ist, wobei das Anschlusselement bspw. als Stecker ausgebildet und/oder im Gehäuse integriert ausgeführt ist. Insbesondere ist dabei das Anschlusselement im Bereich eines Kabelbaums angeordnet.

Weiter kann es möglich sein, dass die Leiterplatte (Platine) im Gehäuse umspritzt und/oder vergossen ist, wobei das Gehäuse vorzugsweise aus Kunststoff hergestellt ist.

Es ist denkbar, dass ein Fahrzeugteilabstand A (d. h. ein Abstand zwischen den jeweiligen Sensorelementen und einem Fahrzeugteil und/oder Deformationsbereich und/oder Aktivierungsmittel) wenigstens oder genau oder maximal in einem Bereich liegt von 0 mm bis 10 mm, vorzugsweise 2 mm bis 5 mm, bevorzugt 0,25 mm bis 4 mm, besonders bevorzugt 1 mm bis 3 mm.

Bevorzugt kann es möglich sein, dass ein Sensorabstand B (d. h. ein Abstand zwischen benachbarten Sensorelementen des Sensorsystems) wenigstens oder genau oder maximal in einem Bereich liegt von 1 cm bis 10 cm, vorzugsweise 2 cm bis 8 cm, bevorzugt 3 cm bis 6 cm.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind.

Es zeigen:
- Figur 1-3: schematische Ansichten eines Fahrzeugs mit einem erfindungsgemäßen Sensorsystem,
- Figur 4+5: schematische Ansichten von Teilen eines erfindungsgemäßen Sensorsystems bzw. eines erfindungsgemäßen Sensormoduls,
- Figur 6+7: weitere schematische Ansichten von Teilen eines erfindungsgemäßen Sensorsystems bzw. eines erfindungsgemäßen Sensormoduls,
- Figur 8+9: weitere schematische Ansichten von Teilen eines erfindungsgemäßen Sensorsystems bzw. eines erfindungsgemäßen Sensormoduls,
- Figur 10+11: weitere schematische Ansichten von Teilen eines erfindungsgemäßen Sensorsystems bzw. eines erfindungsgemäßen Sensormoduls,
- Figur 12: eine schematische Schnittansicht von Teilen eines erfindungsgemäßen Sensorsystems und
- Figur 13: eine weitere schematische Ansicht eines erfindungsgemäßen Sensorsystems,
- Figur 14: eine schematische Darstellung zur Visualisierung eines erfindungsgemäßen Verfahrens.

In den nachfolgenden Figuren werden für die gleichen technischen Merkmale auch von unterschiedlichen Ausführungsbeispielen die identischen Bezugszeichen verwendet.

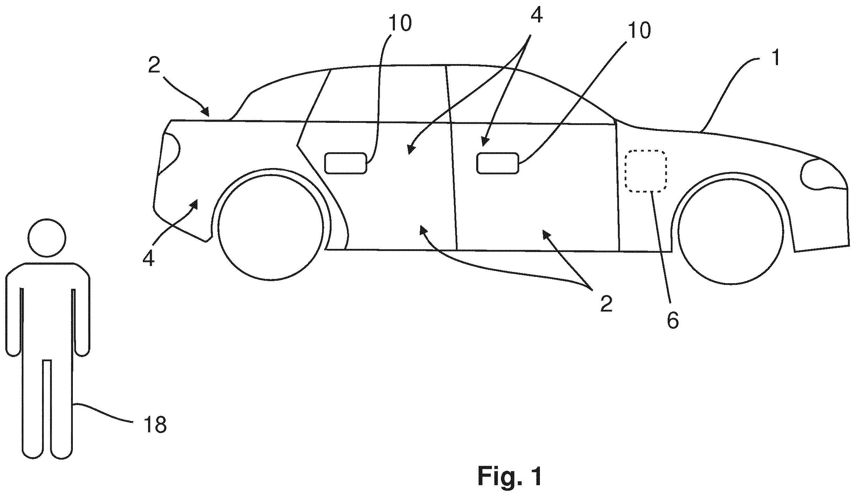

In Figur 1 ist schematisch ein erfindungsgemäßes Fahrzeug 1 in einer Seitenansicht gezeigt. Weiter sind schematisch Türgriffe 10 des Fahrzeugs 1, bewegliche Teile 2 des Fahrzeugs 1 sowie eine Außenverkleidung 4 bzw. wenigstens ein Fahrzeugteil 4 des Fahrzeugs 1 veranschaulicht. Weiter ist eine Fahrzeugelektronik 6 gezeigt, welche vorzugsweise innerhalb des Fahrzeugs 1 angeordnet ist. Im Außenbereich des Fahrzeugs 1 ist zudem ein Benutzer 18 dargestellt, welcher bspw. eine Deformation am Fahrzeugteil 4 von außen durchführen kann.

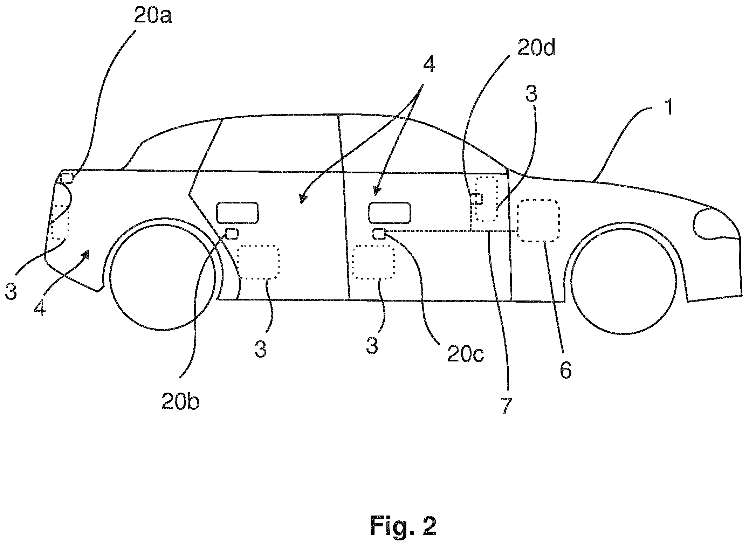

In Figur 2 ist beispielhaft eine Integration eines erfindungsgemäßen Systems 200 in das Fahrzeug 1 dargestellt. Hierzu können mehrere Sensorelemente 20 am Fahrzeug 1 angeordnet und/oder in das Fahrzeug 1 integriert sein. So ist z. B. ein erstes Sensorelement 20a in einem Heckbereich des Fahrzeugs 1, ein zweites Sensorelement 20b im Bereich einer seitlichen hinteren Tür des Fahrzeugs 1, ein drittes Sensorelement 20c im Bereich einer vorderen seitlichen Tür des Fahrzeugs 1 und ein viertes Sensorelement 20d im Bereich eines Handschuhfachs des Fahrzeugs 1 angeordnet. Optional können die genannten Sensorelemente 20 Teile von jeweiligen Sensormodulen 300 bilden. Weiter ist gezeigt, dass den jeweiligen Sensorelementen 20 jeweils eine elektrische Schließvorrichtung 3, insbesondere ein elektrisches Schloss 3, zugeordnet ist. Entsprechend kann wenigstens eine Deformation im Bereich der jeweiligen Sensorelemente 20 zu einer Aktivierung der jeweiligen elektrischen Schließvorrichtung 3 führen.

Des Weiteren ist in Figur 2 dargestellt, dass die Sensorelemente 20 über ein Übertragungssystem 7, insbesondere ein Bussystem 7, miteinander und/oder mit einer Fahrzeugelektronik 6 verbunden sein können.

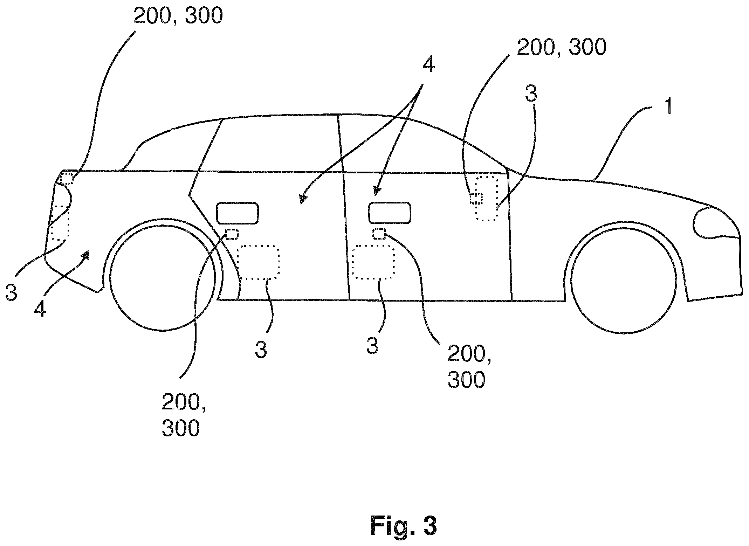

In Figur 3 ist schematisch gezeigt, dass auch mehrere Sensorsysteme 200 und/oder Sensormodule 300 am Fahrzeug 1 an unterschiedlichen Bereichen des Fahrzeugs 1 angeordnet sein können. Bspw. ist hier ein Sensormodul 300 bzw. ein Sensorsystem 200 im Heckbereich, ein weiteres Sensormodul 300 bzw. Sensorsystem 200 im Bereich eines Handschuhfachs im Innenraum des Fahrzeugs 1, sowie zwei weitere Sensormodule 300 bzw. Sensorsysteme 200 im Seitenbereich an jeweiligen Türen des Fahrzeugs 1 angeordnet. Auch hierbei ist es möglich, dass durch wenigstens eine Deformation im Bereich von jeweiligen Sensorelementen 20 der jeweiligen Sensormodule 300 bzw. Sensorsysteme 200 wenigstens eine jeweils zugeordnete elektrische Schließvorrichtung 3 aktiviert werden kann.

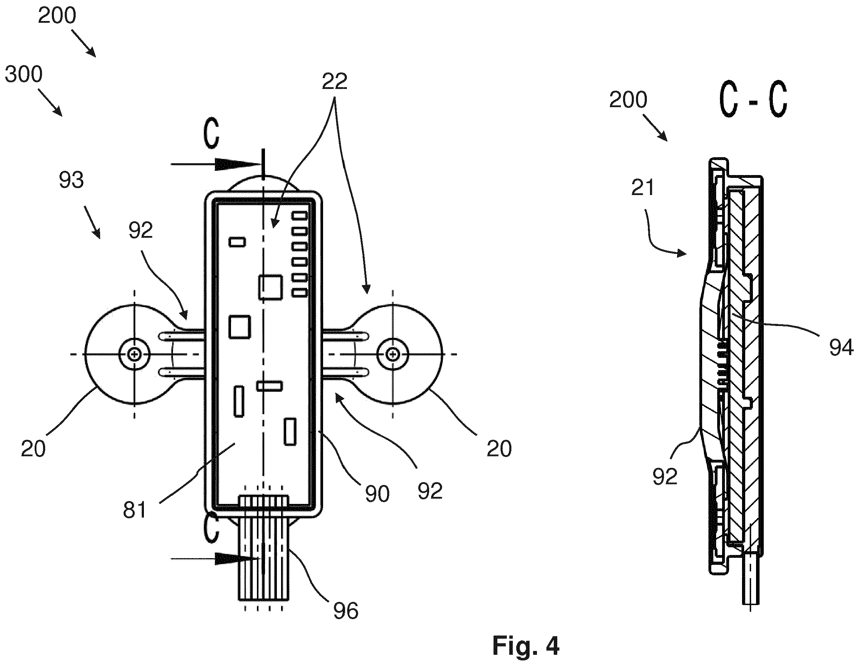

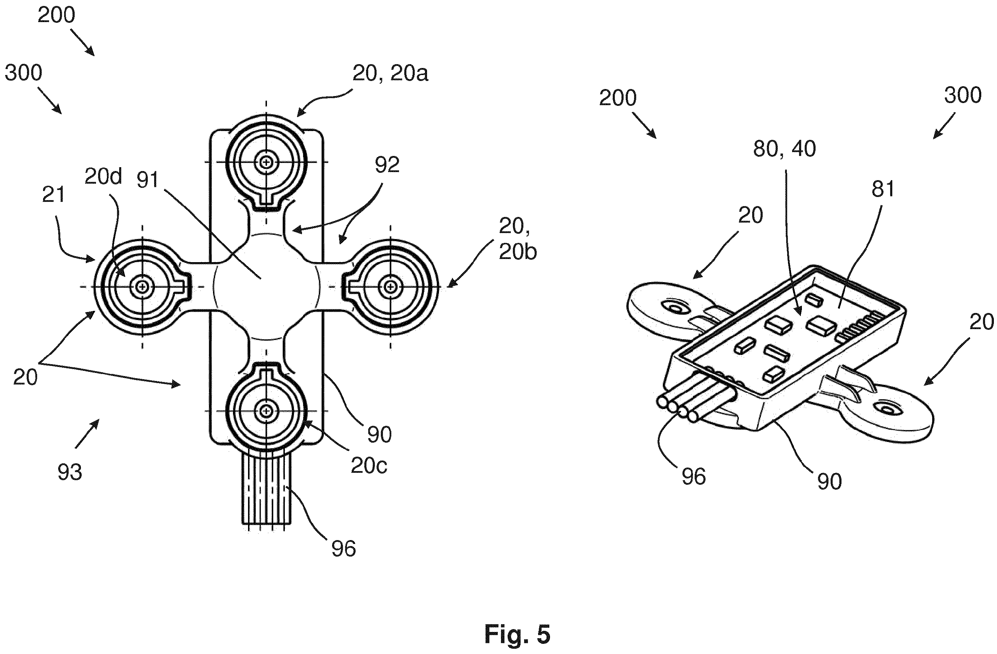

Die Figuren 4 und 5 zeigen schematisch einen Aufbau eines erfindungsgemäßen Systems 200 bzw. eines erfindungsgemäßen Sensormoduls 300, insbesondere gemäß einer ersten Ausführungsvariante. In Figur 4 ist dabei (auf der linken Seite) eine Draufsicht gezeigt sowie (auf der rechten Seite) eine Schnittansicht durch die Ebene C-C des Sensormoduls 300 gezeigt. In Figur 5 ist (auf der linken Seite) eine Rückansicht sowie (auf der rechten Seite) eine perspektivischer Ansicht des erfindungsgemäßen Sensormoduls 300 gezeigt. Dabei ist erkennbar, dass das erfindungsgemäße Sensormodul 300 insgesamt vier Sensorelemente 20 aufweist, welche gemäß einer bestimmten Geometrieanordnung 93 zueinander angeordnet sind. Insbesondere sind hierbei die Sensorelemente 20 kreuzförmig angeordnet, wobei ein erstes Sensorelement 20a und eine drittes Sensorelement 20c auf gegenüberliegenden Seiten angeordnet sind, und ein zweites Sensorelement 20b und ein viertes Sensorelement 20d ebenfalls auf gegenüberliegenden Seiten angeordnet sind (vgl. Figur 5). Des Weiteren ist gemäß den Figuren 4 und 5 erkennbar, dass die Sensorelemente 20 durch ein Gehäuse 90, insbesondere durch einen Abstandshalter 92 und/oder eine Befestigungsstruktur 91, miteinander verbunden sind. Ebenfalls dient dabei der Abstandshalter 92 ggf. dazu, bei einer Montage an einem Fahrzeugteil 4 einen geforderten Fahrzeugteilabstand A zu gewährleisten. Hierzu verbindet der Abstandshalter 92 die Sensorelemente 20 derart mit der Befestigungsstruktur 91, dass die Befestigungsstruktur 91 gegenüber den Sensorelementen 20 hervorragt. Bei der Montage kann dabei das Sensormodul 300 über die Befestigungsstruktur 91 direkt mit dem Fahrzeugteil 4 (oder auch einem anderen Bereich des Fahrzeugs 1) verbunden werden. Insbesondere kontaktiert dabei (lediglich) die Befestigungsstruktur 91 direkt das Fahrzeug 1 bzw. das Fahrzeugteil 4. Dabei wird das Sensormodul 300 insbesondere derart am Fahrzeug 1 montiert, dass ein deformationsseitiger Bereich 21 der Sensorelemente 20 in Richtung des Deformationsbereichs 30 (und/oder zum Fahrzeugteil 4) zeigt bzw. ausgerichtet ist, und vorzugsweise ein fahrzeug(innenraum)seitiger Bereich 22 des Sensormoduls 300 in Richtung des Fahrzeuginnenraums des Fahrzeugs 1 zeigt bzw. ausgerichtet ist. Damit wird gewährleistet, dass ein in Figur 5 (auf der linken Seite) gezeigter deformationsseitiger Bereich 21 des Sensormoduls 300 bzw. der Sensorelemente 20 den notwendigen Mindestabstand zu einem Aktivierungsmittel 31 im Deformationsbereich 30 hat, um eine Induktivitätsmessung durchführen zu können. Diese Induktivitätsmessung ist dabei spezifisch für eine Deformation im Deformationsbereich 30.

Um diese Induktivitätsmessung auswerten zu können, ist insbesondere eine Verarbeitungsvorrichtung 80 vorgesehen. Diese Verarbeitungsvorrichtung 80 kann bspw. über die Leiterbahnen einer Leiterplatte 81 mit den Sensorelementen 20 und/oder mit einer Schnittstellenvorrichtung 40 verbunden sein. Die Schnittstellenvorrichtung 40 dient bspw. dazu, ein Auswertungsergebnis der Auswertung der Verarbeitungsvorrichtung 80 über wenigstens ein elektrisches Verbindungselement 96, insbesondere ein elektrischer Kontakt und/oder ein elektrisches Kabel, einer Fahrzeugelektronik 6 des Fahrzeugs 1 bereitzustellen. Hierzu ist das elektrische Verbindungselement 96 bspw. mit einem Bussystem 7 des Fahrzeugs 1 verbunden.

Außerdem ist, um insbesondere einen Schutz vor äußeren Einwirkungen wie Feuchtigkeit zu gewährleisten, ggf. eine Vergussmasse 94 vorgesehen. Bspw. kann somit die Leiterplatte 81 im Gehäuse 90 vergossen werden.

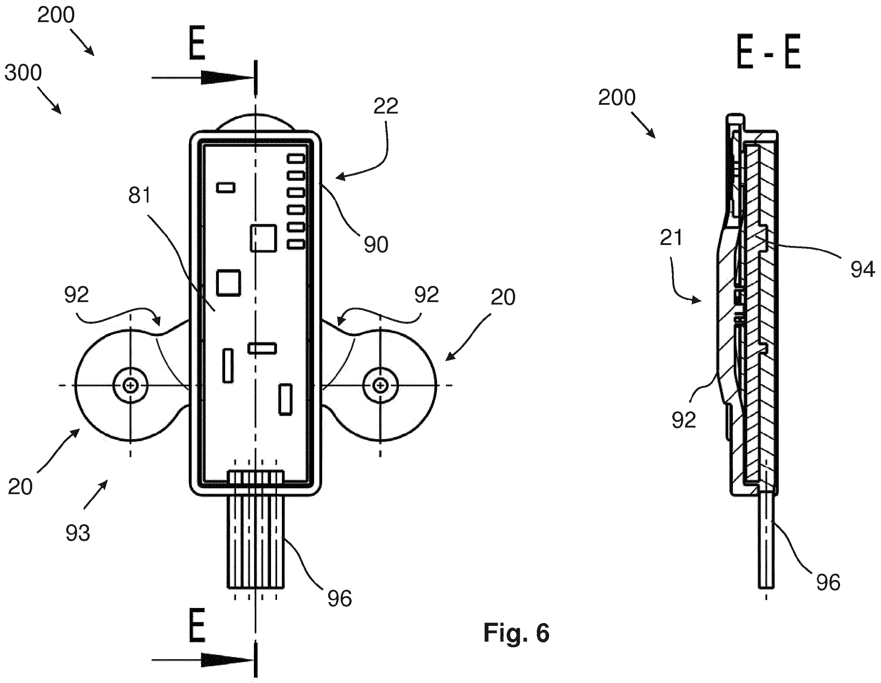

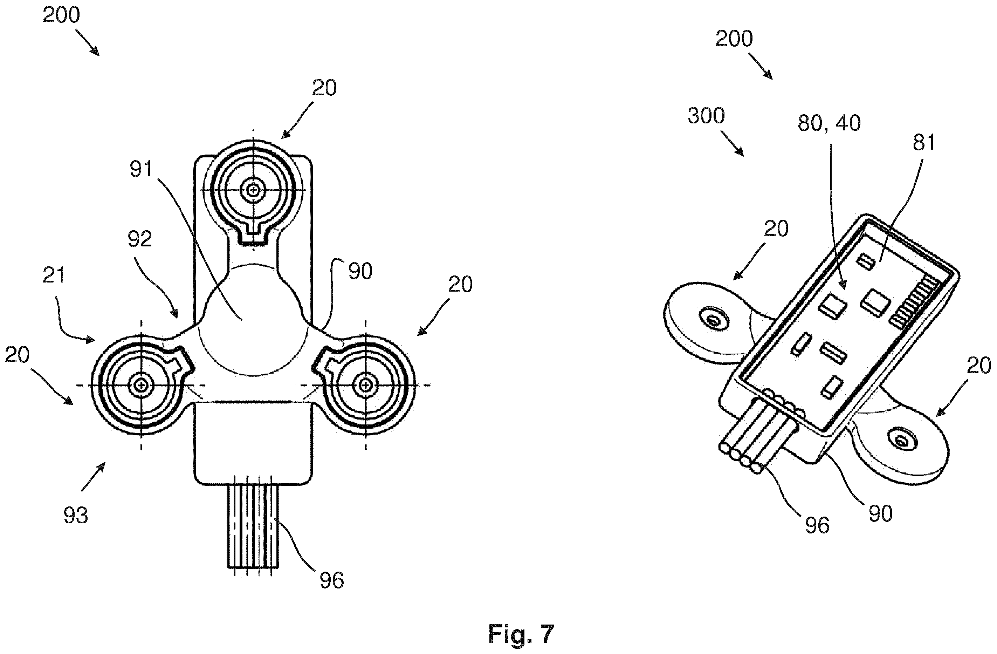

In den Figuren 6 und 7 sind schematisch Teile eines erfindungsgemäßen Sensorsystems 200 bzw. eines erfindungsgemäßen Sensormoduls 300 in unterschiedlichen Ansichten gezeigt. So ist in Figur 6 (auf der linken Seite) eine Draufsicht auf einen fahrzeuginnenraumseitigen Bereich 22 des Sensormoduls 300 gezeigt und (auf der rechten Seite) eine Schnittansicht durch die Ebene E-E gezeigt. In Figur 7 ist (auf der linken Seite) eine Ansicht auf einen deformationsseitigen Bereich 21 des Sensormoduls 300 und (auf der rechten Seite) eine perspektivische Ansicht auf das erfindungsgemäße Sensormodul 300 gezeigt. Auch hier ist ein Gehäuse 90 für das erfindungsgemäße Sensormodul 300 vorgesehen, welches wenigstens einen Abstandshalter 92 und wenigstens eine Befestigungsstruktur 91 umfasst. Die Anordnung der Sensorelemente 20, welches insbesondere durch die Form des Gehäuses 90 bedingt ist, stellt eine dreieckförmige Geometrieanordnung 93 dar. Bevorzugt ist dabei das erfindungsgemäße Sensorsystem 200 bzw. das erfindungsgemäße Sensormodul 300 in den Figuren 6 und 7 gemäß einer zweiten Ausführungsvariante ausgebildet.

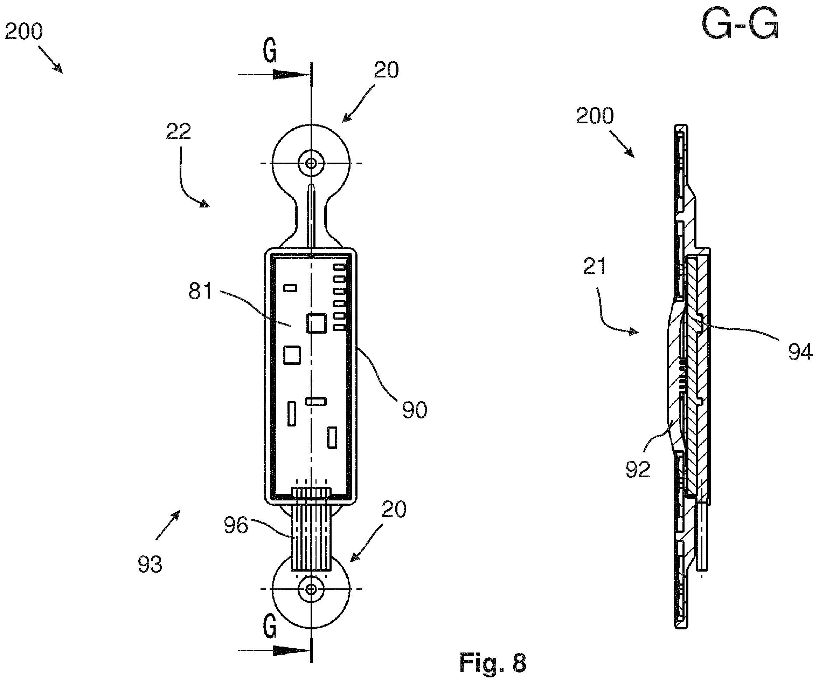

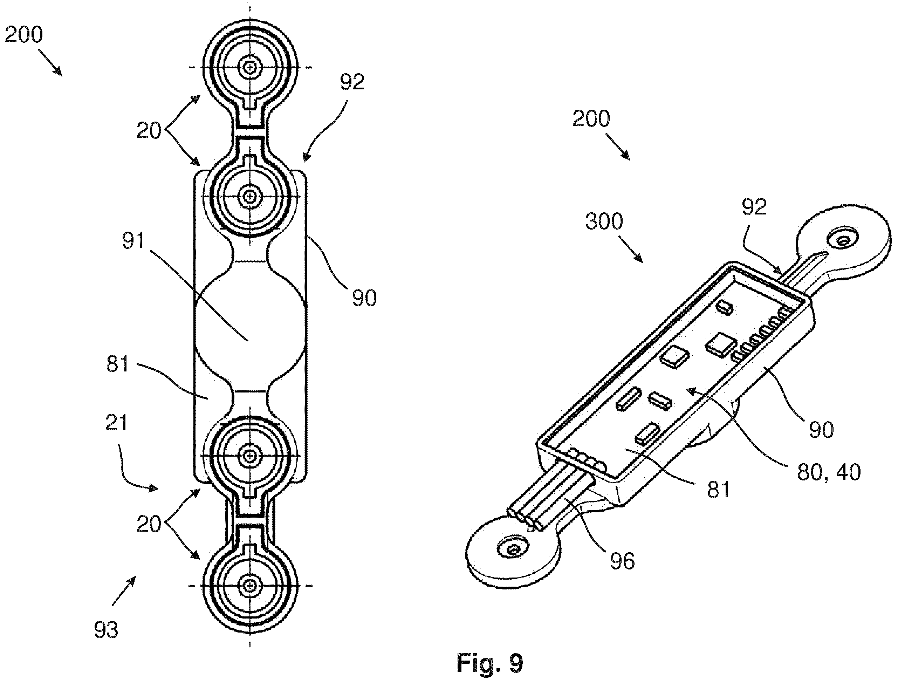

In den Figuren 8 und 9 sind weitere Ansichten eines erfindungsgemäßen Sensorsystems 200 bzw. eines erfindungsgemäßen Sensormoduls 300 gezeigt, welche vorzugsweise gemäß einer dritten Ausführungsvariante ausgebildet sind. Dabei ist (auf der linken Seite) in Figur 8 eine Draufsicht auf einen fahrzeugseitigen Bereich 22 (d. h. einen fahrzeuginnenraumseitigen Bereich 22) und (auf der rechten Seite) eine Schnittansicht durch eine Schnittebene G-G gezeigt. In Figur 9 sind (auf der linken Seite) eine Ansicht eines deformationsseitigen Bereichs 21 und (auf der rechten Seite) eine perspektivische Ansicht des erfindungsgemäßen Sensorsystems 200 bzw. Sensormoduls 300 gezeigt. Hierbei ist die Geometrieanordnung 93 als reihenartig bzw. als Reihe ausgeführt.

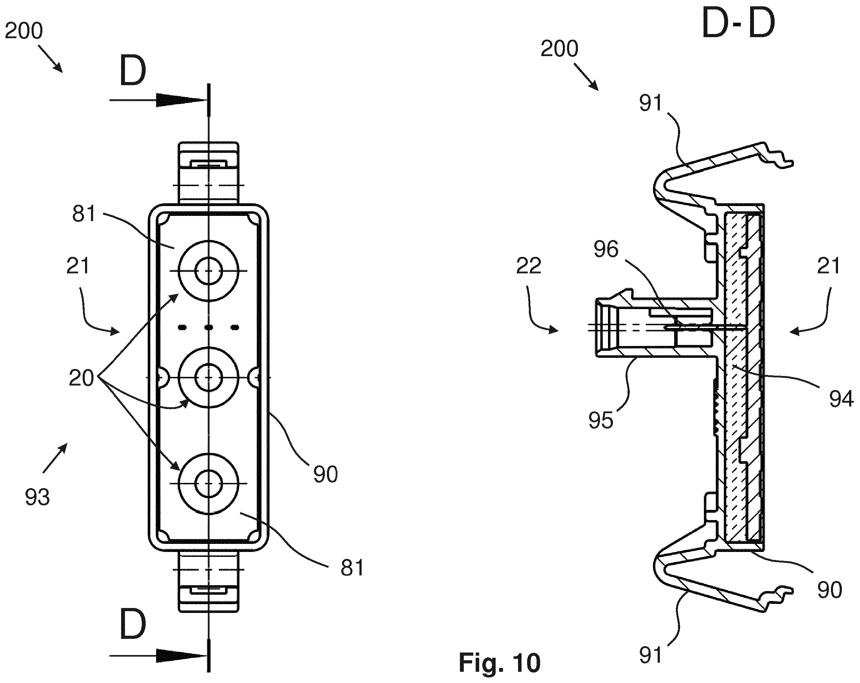

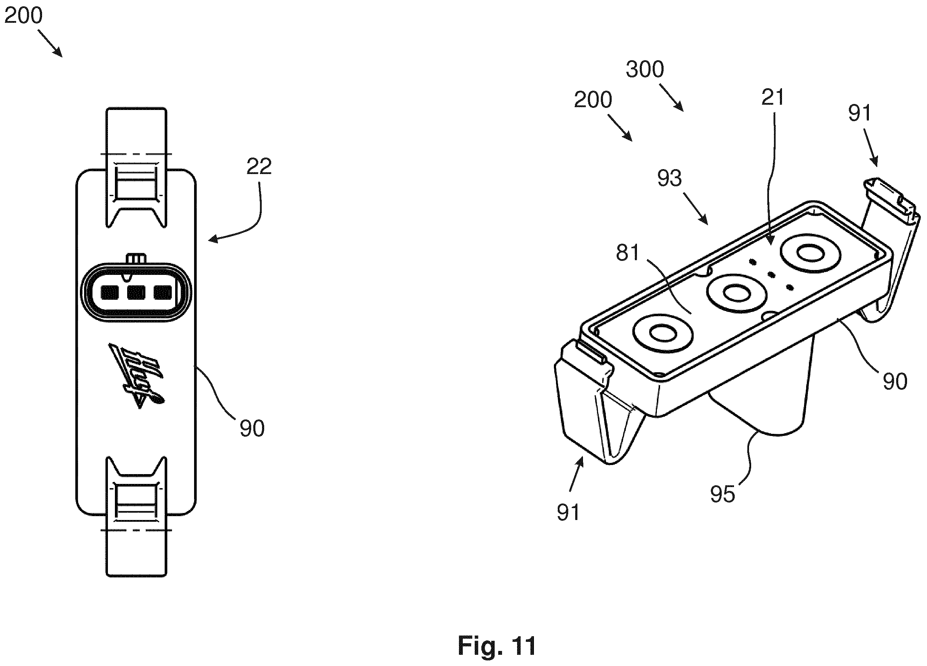

In den Figuren 10 und 11 sind weitere Ansichten eines erfindungsgemäßen Sensorsystems 200 bzw. eines erfindungsgemäßen Sensormoduls 300 gezeigt, wobei insbesondere eine vierte Ausführungsvariante dargestellt ist. In Figur 10 (auf der linken Seite) ist dabei eine Ansicht auf einen deformationsseitigen Bereich 21 gezeigt, und weiter (auf der rechten Seite) eine Schnittansicht durch eine Ebene D-D. Die Geometrieanordnung 93 ist hierbei ebenfalls reihenförmig, wobei lediglich drei Sensorelemente 20 vorgesehen sind. Außerdem ist erkennbar, dass ein Anschlusselement 95 hierbei nicht als Kabel, sondern als Steckelement, insbesondere Stecker, ausgeführt ist. Des Weiteren ist eine Befestigungsstruktur 91, wie in den Figuren 10 und 11 zu sehen ist, als wenigstens ein Clipsfuß ausgeführt. Dies ermöglicht insbesondere eine sichere und/oder lösbare Verbindung am Fahrzeug 1, insbesondere am Fahrzeugteil 4, bevorzugt an einer korrespondierenden Fahrzeugbefestigungsstruktur.

Optional kann es dabei gemäß den gezeigten Ausführungsvarianten vorgesehen sein, dass die Sensorelemente 20 von dem Gehäuse 90 zumindest teilweise umgeben bzw. umspritzt sind, sodass vorzugsweise die Spulen der Sensorelemente 20 geschützt sind. Dies ist bspw. auch in Figur 9 erkennbar.

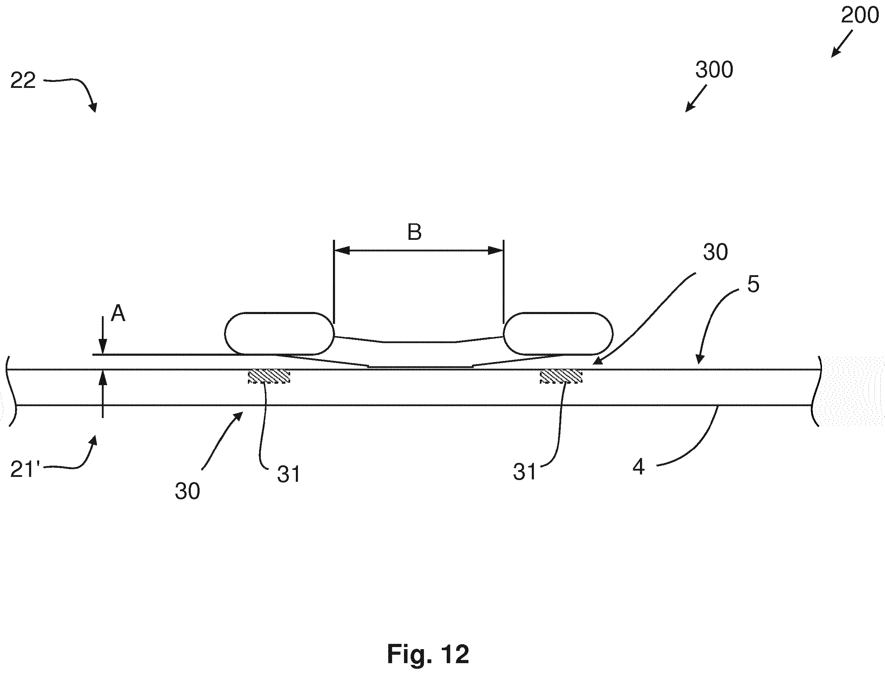

In Figur 12 ist schematisch eine Schnittansicht durch Teile eines erfindungsgemäßen Sensorsystems 200 bzw. durch ein erfindungsgemäßes Sensormodul 300 gezeigt. Dabei ist erkennbar, dass die benachbarten Sensorelemente 20 einen Sensorabstand B voneinander aufweisen können, sodass eine Erfassung in benachbarten oder beabstandeten Deformationsbereichen 30 möglich ist. Hierzu kann in jedem der Deformationsbereiche 30 wenigstens ein Aktivierungsmittel 31, welches induktiv ausgestaltet ist, vorgesehen sein. Dies ermöglicht eine Induktivitätserfassung durch die Sensorelemente 20. Die Aktivierungsmittel 31 können dabei bspw. an einer (fahrzeuginnenraumseitigen) Innenseite 5 eines Fahrzeugteils 4, insbesondere einer Außenverkleidung und/oder Karosserie des Fahrzeugs 1, angeordnet sein. Der Krafteinfluss, welcher zur Deformation im Deformationsbereich 30 führt, bspw. durch das Eindrücken durch einen Benutzer 18, kann bspw. an der Außenseite des Fahrzeugteils 4 bewirkt werden (dies ist entsprechend der deformationsseitige Bereich 21' des Fahrzeugteils 4, wobei eine deformationsseitiger Bereich 21 des erfindungsgemäßen Sensormoduls 300 ebenfalls in Richtung dieser Krafteinwirkung ausgerichtet ist).

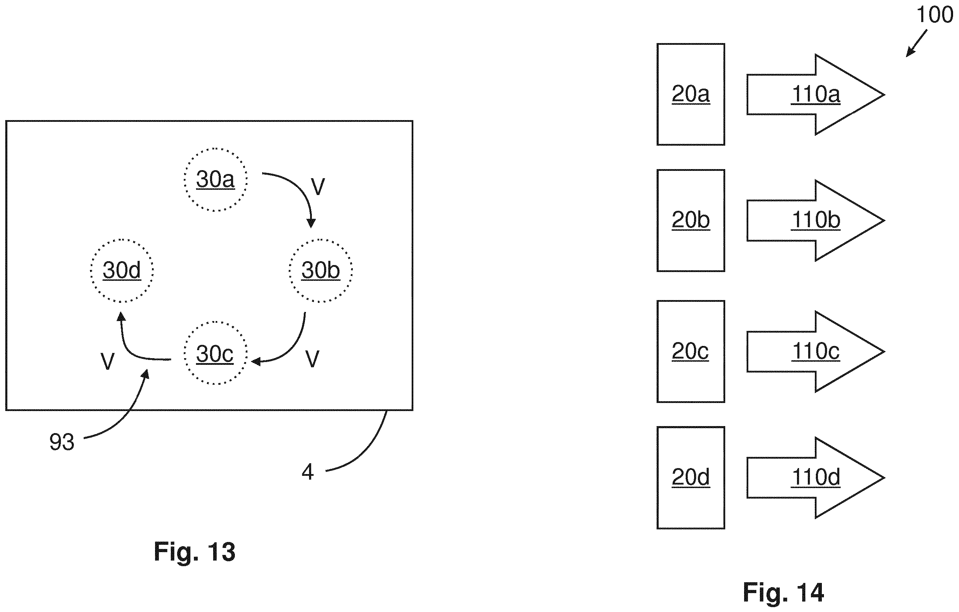

In Figur 13 ist schematisch ein Deformationsverlauf V gezeigt. Bspw. kann gemäß einem kreisförmigen Deformationsverlauf V zunächst eine Deformation in einem ersten Deformationsbereich 30a, anschließend in einem zweiten Deformationsbereich 30b, anschließend in einem dritten Deformationsbereich 30c, und zuletzt in einem vierten Deformationsbereich 30d erfolgen. Entsprechend würde bei einer Auswertung der Erfassung der Sensorelemente 20 zunächst eine Detektion einer Deformation bei einem ersten Sensorelement 20a, anschließend bei einem zweiten Sensorelement 20b, anschließend bei einem dritten Sensorelement 20c und zuletzt bei einem vierten Sensorelement 20d erfolgen. Weiter wird aus Figur 13 deutlich, dass eine Geometrieanordnung 93 der Sensorelemente 20 mit den Deformationsbereichen 30 am Fahrzeugteil 4 korrespondiert. Die Anordnung der Deformationsbereiche 30 entspricht dabei bspw. einer Kreuzform, welche bspw. zu einer kreuzförmigen (kreuzartigen) Geometrieanordnung 93 korrespondiert (vgl. Figur 5). Hieraus wird auch deutlich, dass sich durch die kreuzförmige Geometrieanordnung 93 auch eine kreisförmige Geste (d. h. ein kreisförmiger Deformationsverlauf V) detektieren lässt.

In Figur 14 ist schematisch zur Visualisierung eines erfindungsgemäßen Verfahrens 100 dargestellt, dass zur Auswertung der Erfassung der Sensorelemente 20 ein erstes Erfassungssignal 110a, ein zweites Erfassungssignal 110b, ein drittes Erfassungssignal 110c und/oder ein viertes Erfassungssignal 110d ausgewertet werden können, welche jeweils entsprechenden ersten bis vierten Sensorelementen 20 zugeordnet sind bzw. durch diese bereitgestellt werden. Anhand der jeweiligen Erfassungssignale 110 kann die Deformation in entsprechenden ersten bis vierten Deformationsbereichen 30 detektiert werden.

Die voranstehende Erläuterung der Ausführungsformen beschreibt die vorliegende Erfindung ausschließlich im Rahmen von Beispielen.

### Bezuqszeichenliste

- 1: Fahrzeug
- 2: bewegliches Teil
- 3: elektrische Schließvorrichtung, elektrisches Schloss
- 4: Außenverkleidung, Karosserie, Fahrzeugteil
- 5: Innenseite
- 6: Fahrzeugelektronik
- 7: Bussystem

- 10: Türgriff
- 18: Benutzer

- 20: Sensorelement, Spule, LDC-Spule
- 20a: erstes Sensorelement
- 20b: zweites Sensorelement
- 20c: drittes Sensorelement
- 20d: viertes Sensorelement
- 21: Deformationsseitiger Bereich von 300
- 21': Deformationsseitiger Bereich von 4
- 22: Fahrzeug(innenraum)seitiger Bereich

- 30: Deformationsbereich
- 30a: erster Deformationsbereich
- 30b: zweiter Deformationsbereich
- 30c: dritter Deformationsbereich
- 30d: vierter Deformationsbereich
- 31: Aktivierungsmittel

- 40: Schnittstellenvorrichtung

- 80: Verarbeitungsvorrichtung
- 81: Leiterplatte

- 90: Gehäuse
- 91: Befestigungsstruktur, Klebefläche, Clipsfüße
- 92: Abstandshalter
- 93: Geometrieanordnung
- 94: Vergussmasse
- 95: Anschlusselement, Stecker
- 96: elektrisches Verbindungselement, Kontakt, Kabel

- 100: Verfahren

- 110a: erstes Erfassungssignal
- 110b: zweiten Erfassungssignal
- 110c: drittes Erfassungssignal
- 110d: viertes Erfassungssignal

- 200: Sensorsystem
- 300: Sensormodul

- A: Fahrzeugteilabstand
- B: Sensorabstand
- V: Deformationsverlauf

## Patentansprüche

1. Sensorsystem (200) zur Aktivierung wenigstens einer Fahrzeugfunktion eines Fahrzeuges (1), vorzugsweise zur Aktivierung wenigstens eines elektrischen Schlosses (3) des Fahrzeuges (1), aufweisend:
- wenigstens ein erstes und zweites Sensorelement (20a, 20b) jeweils zur Erfassung einer Deformation in zumindest einem Deformationsbereich (30a, 30b) am Fahrzeug (1),
- wenigstens eine Verarbeitungsvorrichtung (80) zur Auswertung der jeweiligen Erfassung der Sensorelemente (20a, 20b),
**dadurch gekennzeichnet,**
**dass** ein durch die Sensorelemente (20a, 20b) erfasster Deformationsverlauf (V) durch die Verarbeitungsvorrichtung (80) auswertbar ist, sodass in Abhängigkeit von dem erfassten Deformationsverlauf (V) die wenigstens eine Fahrzeugfunktion aktivierbar ist, wobei das wenigstens erste und zweite Sensorelement (20a, 20b) jeweils zur Induktivitätsmessung ausgeführt sind, sodass ein Messergebnis der Induktivitätsmessung für die Deformation in einem jeweiligen Deformationsbereich (30a, 30b) an einer Außenverkleidung (4) des Fahrzeuges (1), spezifisch ist, und
eine Geometrieanordnung (93) von wenigstens drei der Sensorelemente (20) vorgesehen ist, wobei wenigstens das erste Sensorelement (20a) mit mindestens einem Sensorabstand (B) beabstandet von dem zweiten Sensorelement (20b) und den weiteren Sensorelementen (20) angeordnet ist, sodass der Deformationsverlauf (V) in Abhängigkeit von der Geometrieanordnung (93) erfassbar ist.

2. Sensorsystem (200) nach Anspruch 1,
**dadurch gekennzeichnet,**
**dass** der wenigstens eine Deformationsbereich (30) jeweils einen Bereich eines Fahrzeugteils (4), insbesondere einer Außenverkleidung (4) des Fahrzeuges (1), umfasst, insbesondere außerhalb eines Türgriffs (10).

3. Sensorsystem (200) nach einem der vorhergehenden Ansprüche,
**dadurch gekennzeichnet,**
**dass** eine Geometrieanordnung (93) von wenigstens vier oder fünf der Sensorelemente (20) vorgesehen ist, wobei vorzugsweise wenigstens das erste Sensorelement (20a) mit mindestens einem Sensorabstand (B) beabstandet von dem zweiten Sensorelement (20b) und/oder den weiteren Sensorelementen (20) angeordnet ist, sodass der Deformationsverlauf (V) in Abhängigkeit von der Geometrieanordnung (93) erfassbar ist, und/oder dass das wenigstens eine erste und zweite Sensorelement (20a, 20b), und insbesondere weitere Sensorelemente (20), in einer Geometrieanordnung (93) mit festen Sensorabständen (B) zueinander angeordnet sind, und vorzugsweise fest miteinander über ein Gehäuse (90) verbunden sind, und insbesondere zumindest teilweise gemäß der Geometrieanordnung (93) kreisförmig oder rechteckig oder polygonal oder rautenförmig oder reihenförmig oder trapezförmig oder quadratförmig oder ellipsenförmig oder rhombusförmig oder sternförmig oder kreuzförmig angeordnet sind.

4. Sensorsystem (200) nach einem der vorhergehenden Ansprüche,
**dadurch gekennzeichnet,**
**dass** die Sensorelemente (20) jeweils als LDC-Sensorelement, insbesondere als LDC-Spule, ausgeführt sind, sodass das Sensorsystem (200) als ein LDC-Sensorsystem ausgeführt ist.

5. Sensorsystem (200) nach einem der vorhergehenden Ansprüche,
**dadurch gekennzeichnet,**
**dass** ein Gehäuse (90) vorgesehen ist, insbesondere zur zumindest teilweisen Aufnahme und/oder Anordnung der Sensorelemente (20) und/oder der Verarbeitungsvorrichtung (80) und/oder einer Leiterplatte (81), wobei vorzugsweise die Leiterplatte (81) im Gehäuse (90) umspritzt und/oder mit Vergussmasse (94) vergossen ist, wobei bevorzugt das Gehäuse (90) eine Befestigungsstruktur (91) zur Befestigung wenigstens der Sensorelemente (20) an ein Fahrzeugteil (4), vorzugsweise einer Außenverkleidung (4) des Fahrzeuges (1), aufweist,
und/oder dass ein Gehäuse (90) vorgesehen ist, welches wenigstens einen Abstandshalter (92) umfasst, sodass bei einer Befestigung des Gehäuses (90) an einem Fahrzeugteil (4) die Sensorelemente (20) jeweils beabstandet zu einem jeweiligen, insbesondere induktiven, Aktivierungsmittel (31) im Deformationsbereich (30) angeordnet sind, sodass vorzugsweise eine jeweilige Deformation im Deformationsbereich (30) mit dem jeweiligen Aktivierungsmittel (31) zu einer Relativbewegung des jeweiligen Aktivierungsmittels (31) in Bezug zu dem jeweiligen beabstandeten Sensorelement (20) führt.

6. Sensorsystem (200) nach einem der vorhergehenden Ansprüche,
**dadurch gekennzeichnet,**
**dass** eine Schnittstellenvorrichtung (40) vorgesehen ist, um ein Ergebnis der Auswertung des Deformationsverlaufs (V) an eine, insbesondere zentrale, Fahrzeugelektronik (6) zu übertragen, wobei bevorzugt die Schnittstellenvorrichtung (40) zur Verbindung mit einem Bussystem (7) des Fahrzeuges (1) ausgeführt ist, besonders bevorzugt mit einem LIN- oder CAN-Bus oder einer Trägerfrequenzanlage,
und/oder dass das Sensorsystem (200) über eine Schnittstellenvorrichtung (40) mit einem Übertragungssystem (7), insbesondere einer Trägerfrequenzanlage (7), verbindbar ist, sodass sowohl eine Energieversorgung für das Sensorsystem (200) als auch eine Datenübertragung, insbesondere zwischen der Verarbeitungsvorrichtung (80) und einer Fahrzeugelektronik (6), über das Übertragungssystem (7), insbesondere über identische elektrische Leiter, bereitgestellt ist.

7. Sensorsystem (200) nach einem der vorhergehenden Ansprüche,
**dadurch gekennzeichnet,**
**dass** ein Bereich zwischen den jeweiligen Sensorelementen (20), und insbesondere wenigstens einen jeweils zugeordneten Aktivierungsmittel (60), zumindest teilweise mit einem Füllelement, insbesondere Vergussmasse (94), ausgefüllt ist.

8. Sensormodul (300) zur Aktivierung wenigstens einer Fahrzeugfunktion eines Fahrzeuges (1), vorzugsweise zur Aktivierung wenigstens eines elektrischen Schlosses (3) des Fahrzeuges (1), mit wenigstens einem ersten und wenigstens einem zweiten Sensorelement (20a, 20b), und mit einem Gehäuse (90), welches wenigstens eine Befestigungsstruktur (91) aufweist,
**dadurch gekennzeichnet,**
**dass** die Sensorelemente (20) über die Befestigungsstruktur (91) des Gehäuses (90) miteinander fest verbunden sind, sodass die Sensorelemente (20) eine Geometrieanordnung (93) bilden, wobei das Sensormodul (300) durch die Befestigungsstruktur (91) derart an ein Fahrzeugteil (4) des Fahrzeuges (1) befestigbar ist, dass die Geometrieanordnung (93) mit wenigstens einem Deformationsbereich (30) am Fahrzeugteil (4) korrespondiert,
wobei das wenigstens erste und zweite Sensorelement (20a, 20b) jeweils zur Induktivitätsmessung ausgeführt sind, sodass ein Messergebnis der Induktivitätsmessung für die Deformation in einem jeweiligen Deformationsbereich (30a, 30b) an einer Außenverkleidung (4) des Fahrzeuges (1), spezifisch ist, und
eine Geometrieanordnung (93) von wenigstens drei der Sensorelemente (20) vorgesehen ist, wobei wenigstens das erste Sensorelement (20a) mit mindestens einem Sensorabstand (B) beabstandet von dem zweiten Sensorelement (20b) und den weiteren Sensorelementen (20) angeordnet ist, sodass der Deformationsverlauf (V) in Abhängigkeit von der Geometrieanordnung (93) erfassbar ist.

9. Sensormodul (300) nach einem der vorhergehenden Ansprüche,
**dadurch gekennzeichnet,**
**dass** das Sensormodul (300) als ein einzeln handhabbares Modul ausgeführt ist, vorzugsweise zur Befestigung an einer Innenseite (5) des Fahrzeugteils (4), vorzugsweise einer Außenverkleidung (4) und/oder eines Türgriffs (10) des Fahrzeuges (1),
und/oder dass das Sensormodul (300) gemäß einem Sensorsystem (200) nach einem der vorhergehenden Ansprüche ausgeführt ist.

10. Fahrzeug (1), insbesondere Kraftfahrzeug (1),
mit wenigstens einem Sensorsystem (200) nach einem der vorhergehenden Ansprüche und/oder mit wenigstens einem Sensormodul (300) nach einem der vorhergehenden Ansprüche,
**dadurch gekennzeichnet,**
**dass** ein erstes Sensorsystem (200) und/oder erstes Sensormodul (300) an einem ersten Bereich des Fahrzeuges (1), insbesondere in einem Heckbereich des Fahrzeuges (1), angeordnet ist, und ein zweites Sensorsystem (200) und/oder zweites Sensormodul (300) an einem zweiten Bereich des Fahrzeuges (1), insbesondere in einem Seitenbereich des Fahrzeuges (1), angeordnet ist, sodass Deformationsverläufe (V) an den unterschiedlichen Bereichen des Fahrzeuges (1) erfassbar sind, um insbesondere jeweils unterschiedliche Fahrzeugfunktionen zu aktivieren,
und/oder dass die unterschiedlichen Fahrzeugfunktionen jeweils eine Aktivierung jeweils eines elektrischen Schlosses (3) umfassen, insbesondere zum Freigeben und/oder Öffnen von beweglichen Teilen (2) des Fahrzeuges (1) mit den jeweiligen Fahrzeugteilen (4).

11. Verfahren (100) zur Aktivierung wenigstens einer Fahrzeugfunktion eines Fahrzeuges (1), vorzugsweise zur Aktivierung wenigstens eines elektrischen Schlosses (3) des Fahrzeuges (1), mit wenigstens einem ersten und wenigstens einem zweiten Sensorelement (20a, 20b),
**gekennzeichnet durch die nachfolgenden Schritte:**
a) Durchführen einer ersten Erfassung **durch** das erste Sensorelement (20a), wobei die erste Erfassung für eine erste Deformation in einem ersten Deformationsbereich (30a) am Fahrzeug (1) spezifisch ist,
b) Durchführen wenigstens einer zweiten Erfassung **durch** das wenigstens zweite Sensorelement (20b), wobei die wenigstens zweite Erfassung für wenigstens eine zweite Deformation in wenigstens einem zweiten Deformationsbereich (30b) am Fahrzeug (1) spezifisch ist,
c) Auswerten der ersten und der wenigstens zweiten Erfassung, sodass wenigstens ein Deformationsverlauf (V) bestimmt wird,
d) Aktivieren der wenigstens einen Fahrzeugfunktion anhand des bestimmten Deformationsverlaufs (V),
wobei das wenigstens erste und zweite Sensorelement (20a, 20b) jeweils zur Induktivitätsmessung ausgeführt sind, sodass ein Messergebnis der Induktivitätsmessung für die Deformation in einem jeweiligen Deformationsbereich (30a, 30b) an einer Außenverkleidung (4) des Fahrzeuges (1), spezifisch ist, und
eine Geometrieanordnung (93) von wenigstens drei der Sensorelemente (20) vorgesehen ist, wobei wenigstens das erste Sensorelement (20a) mit mindestens einem Sensorabstand (B) beabstandet von dem zweiten Sensorelement (20b) und den weiteren Sensorelementen (20) angeordnet ist, sodass der Deformationsverlauf (V) in Abhängigkeit von der Geometrieanordnung (93) erfassbar ist.

12. Verfahren (100) nach einem der vorhergehenden Ansprüche,
**dadurch gekennzeichnet,**
**dass** die Auswertung gemäß Schritt c) einen Vergleich der ersten mit der wenigstens zweiten Erfassung umfasst, sodass der Deformationsverlauf (V) für eine Geste eines Benutzers (18) des Fahrzeuges (1) in den Deformationsbereichen (30a, 30b) spezifisch ist,
und/oder dass bei Schritt c) ein erster Deformationsverlauf (V) von einem zweiten Deformationsverlauf (V) unterschieden wird, wobei gemäß Schritt d) eine erste Fahrzeugfunktion aktiviert wird, wenn der erste Deformationsverlauf (V) bestimmt wird, und eine zweite Fahrzeugfunktion aktiviert wird, wenn der zweite Deformationsverlauf (V) bestimmt wird.

13. Verfahren (100) nach einem der vorhergehenden Ansprüche,
**dadurch gekennzeichnet,**
**dass** gemäß Schritt c) zur Bestimmung des Deformationsverlaufs (V) wenigstens ein erstes Erfassungssignal (110a) und wenigstens ein zweites Erfassungssignal (110b), und vorzugsweise wenigstens ein drittes und viertes Erfassungssignal (110c, 110d), von jeweils unterschiedlichen Sensorelementen (20) miteinander verglichen werden, wobei die Erfassungssignale jeweils eine zeitabhängige Information umfassen, sodass durch das Auswerten ein zeitliches Deformationsmuster bestimmt wird,
und/oder dass der Deformationsverlauf (V) für eine mechanische Geste an einem Fahrzeugteil (4) spezifisch ist, wobei insbesondere die mechanische Geste zur elastischen Verformung des Fahrzeugteils (4) und/oder Bewegung wenigstens eines Aktivierungsmittels (31) relativ zu wenigstens einem der Sensorelemente (20) führt.

14. Verfahren (100) nach einem der vorhergehenden Ansprüche,
**dadurch gekennzeichnet,**
**dass** bei Schritt c) anhand der Erfassungen und/oder des Deformationsverlaufs (V) eine Geschwindigkeit einer Durchführung und/oder Abfolge von Aktivierungshandlungen bestimmt wird, wobei die Aktivierungshandlungen jeweils wenigstens eine Deformation in wenigstens einem der Deformationsbereiche (30a, 30b) umfassen,
und/oder dass gemäß Schritt c) eine Aktivierungsbewegung und/oder Abfolge von Aktivierungshandlungen in eine erste Richtung von einer Aktivierungsbewegung und/oder Abfolge von Aktivierungshandlungen in eine zweite Richtung anhand der Auswertung unterschieden wird, wobei vorzugsweise eine kreisförmige von einer linearen Aktivierungsbewegung und/oder Abfolge unterschieden wird, um jeweils zugeordnete unterschiedliche Fahrzeugfunktionen zu aktivieren, wobei die Aktivierungshandlungen und/oder die Aktivierungsbewegungen jeweils wenigstens eine Deformation in wenigstens einem der Deformationsbereiche (30a, 30b) umfassen, und/oder dass zumindest das Auswerten gemäß Schritt c) durch eine Verarbeitungsvorrichtung (80) durchgeführt wird, wobei durch die Verarbeitungsvorrichtung (80) ein Auswertungsergebnis der Auswertung einer Fahrzeugelektronik, insbesondere über eine elektrische Schnittstelle und/oder Schnittstellenvorrichtung (40), bereitgestellt wird, wobei vorzugsweise das Auswertungsergebnis die zu aktivierende Fahrzeugfunktion indiziert.

15. Verfahren (100) nach einem der vorhergehenden Ansprüche,
**dadurch gekennzeichnet,**
**dass** das Auswerten der ersten und/oder der wenigstens zweiten Erfassung derart erfolgt, dass wenigstens ein Krafteinfluss bestimmt wird, welcher mit wenigstens einer der jeweiligen Deformationen korreliert ist,
und/oder dass zumindest das Auswerten gemäß Schritt c) durch eine Verarbeitungsvorrichtung (80) durchgeführt wird, wobei die Verarbeitungsvorrichtung (80) gemäß einem Sensorsystem (200) und/oder Sensormodul (300) nach einem der vorhergehenden Ansprüche ausgeführt ist.

## Claims

1. Sensor system (200) for activating at least one vehicle function of a vehicle (1), preferably for activating at least one electric lock (3) of the vehicle (1):
- at least one first and second sensor element (20a, 20b) each for detecting a deformation in at least one deformation region (30a, 30b) on the vehicle (1),
- at least one processing device (80) for evaluating the respective detection of the sensor elements (20a, 20b),
**characterized in that,**
a deformation profile (V) detected by the sensor elements (20a, 20b) can be evaluated by the processing device (80), so that the at least one vehicle function can be activated as a function of the detected deformation profile (V),
wherein the at least first and second sensor elements (20a, 20b) are each designed for inductance measurement, so that a measurement result of the inductance measurement is specific for the deformation in a respective deformation region (30a, 30b) on an outer panel (4) of the vehicle (1), and
a geometry arrangement (93) of at least three of the sensor elements (20) is provided, at least the first sensor element (20a) being arranged at a distance (B) from the second sensor element (20b) and the other sensor elements (20), so that the deformation profile (V) can be detected as a function of the geometry arrangement (93).

2. Sensor system (200) according to claim 1,
**characterized in that**
the at least one deformation region (30) in each case comprises a region of a vehicle part (4), in particular of an outer panel (4) of the vehicle (1), in particular outside a door handle (10).

3. Sensor system (200) according to one of the preceding claims,
**characterized in that**
a geometry arrangement (93) of at least four or five of the sensor elements (20) is provided, at least the first sensor element (20a) preferably being arranged at a distance (B) from the second sensor element (20b) and/or the other sensor elements (20), so that the deformation profile (V) can be detected as a function of the geometry arrangement (93),
and/or **in that** the at least one first and second sensor element (20a, 20b), and in particular further sensor elements (20), are arranged in a geometrical arrangement (93) with fixed sensor distances (B) from one another, and are preferably firmly connected to one another via a housing (90), and in particular are arranged at least partially in a circular or rectangular or polygonal or diamond-shaped or row-shaped or trapezoidal or square-shaped or elliptical or rhombus-shaped or star-shaped or cross-shaped in accordance with the geometry arrangement (93).

4. Sensor system (200) according to one of the preceding claims,
**characterized in that**
the sensor elements (20) are each designed as an LDC sensor element, in particular as an LDC coil, so that the sensor system (200) is designed as an LDC sensor system.

5. Sensor system (200) according to one of the preceding claims,
**characterized in that**
a housing (90) is provided, in particular for at least partially accommodating and/or arranging the sensor elements (20) and/or the processing device (80) and/or a printed circuit board (81), the printed circuit board (81) preferably being encapsulated in the housing (90) and/or cast with casting compound (94), the housing (90) preferably having a fastening structure (91) for fastening at least the sensor elements (20) to a vehicle part (4), preferably an outer panel (4) of the vehicle (1),
and/or **in that** a housing (90) is provided, which comprises at least one spacer (92), so that when the housing (90) is attached to a vehicle part (4), the sensor elements (20) are each arranged at a distance from a respective, in particular inductive, activation means (31) in the deformation region (30), so that preferably a respective deformation in the deformation region (30) with the respective activation means (31) leads to a relative movement of the respective activation means (31) in relation to the respective spaced sensor element (20).

6. Sensor system (200) according to one of the preceding claims,
**characterized in that**
an interface device (40) is provided in order to transmit a result of the evaluation of the deformation profile (V) to a, in particular central, vehicle electronics system (6), the interface device (40) preferably being designed for connection to a bus system (7) of the vehicle (1), particularly preferably to a LIN or CAN bus or a carrier frequency system, and/or **in that** the sensor system (200) can be connected via an interface device (40) to a transmission system (7), in particular a carrier frequency system (7), so that both a power supply for the sensor system (200) and a data transmission, in particular between the processing device (80) and a vehicle electronics system (6), are provided via the transmission system (7), in particular via identical electrical conductors.

7. Sensor system (200) according to one of the preceding claims,
**characterized in that**
an area between the respective sensor elements (20), and in particular at least one respectively assigned activation means (60), is at least partially filled with a filling element, in particular a casting compound (94).

8. Sensor module (300) for activating at least one vehicle function of a vehicle (1), preferably for activating at least one electric lock (3) of the vehicle (1), having at least one first and at least one second sensor element (20a, 20b), and having a housing (90) which has at least one fastening structure (91),
**characterized in that**
the sensor elements (20) are firmly connected to one another via the fastening structure (91) of the housing (90), so that the sensor elements (20) form a geometry arrangement (93), wherein the sensor module (300) can be fastened to a vehicle part (4) of the vehicle (1) by the fastening structure (91) in such a way that the geometry arrangement (93) corresponds to at least one deformation region (30) on the vehicle part (4),
wherein the at least first and second sensor elements (20a, 20b) are each designed for inductance measurement, so that a measurement result of the inductance measurement is specific for the deformation in a respective deformation region (30a, 30b) on an outer panel (4) of the vehicle (1), and
a geometry arrangement (93) of at least three of the sensor elements (20) is provided, at least the first sensor element (20a) being arranged at a distance (B) from the second sensor element (20b) and the other sensor elements (20), so that the deformation profile (V) can be detected as a function of the geometry arrangement (93).

9. Sensor module (300) according to one of the preceding claims,
**characterized in that**
the sensor module (300) is designed as a module that can be handled individually, preferably for attachment to an inner side (5) of the vehicle part (4), preferably an outer panel (4) and/or a door handle (10) of the vehicle (1),
and/or **in that** the sensor module (300) is designed in accordance with a sensor system (200) according to one of the preceding claims.

10. Vehicle (1), in particular motor vehicle (1),
with at least one sensor system (200) according to one of the preceding claims and/or with at least one sensor module (300) according to one of the preceding claims, **characterized in that**
a first sensor system (200) and/or first sensor module (300) is arranged at a first area of the vehicle (1), in particular in a rear area of the vehicle (1), and a second sensor system (200) and/or second sensor module (300) is arranged at a second area of the vehicle (1), in particular in a side area of the vehicle (1), so that deformation profiles (V) can be detected at the different areas of the vehicle (1), in particular in order to activate different vehicle functions in each case,
and/or **in that** the various vehicle functions each comprise activation of a respective electric lock (3), in particular for releasing and/or opening moving parts (2) of the vehicle (1) with the respective vehicle parts (4).

11. Method (100) for activating at least one vehicle function of a vehicle (1), preferably for activating at least one electric lock (3) of the vehicle (1), having at least one first and at least one second sensor element (20a, 20b),
**characterized by the following steps:**
a) performing a first detection by the first sensor element (20a), wherein the first detection is specific to a first deformation in a first deformation region (30a) on the vehicle (1),
b) performing at least a second detection by the at least second sensor element (20b), wherein the at least second detection is specific to at least a second deformation in at least a second deformation region (30b) on the vehicle (1),
c) evaluating the first and at least the second acquisition so that at least one deformation profile (V) is determined,
d) Activation of the at least one vehicle function based on the determined deformation profile (V),
wherein the at least first and second sensor elements (20a, 20b) are each designed for inductance measurement, so that a measurement result of the inductance measurement is specific for the deformation in a respective deformation region (30a, 30b) on an outer panel (4) of the vehicle (1), and
a geometry arrangement (93) of at least three of the sensor elements (20) is provided, at least the first sensor element (20a) being arranged at a distance (B) from the second sensor element (20b) and the other sensor elements (20), so that the deformation profile (V) can be detected as a function of the geometry arrangement (93).

12. The method (100) according to any one of the preceding claims,
**characterized in that**
the evaluation according to step c) comprises a comparison of the first with the at least second detection, so that the deformation profile (V) is specific for a gesture of a user (18) of the vehicle (1) in the deformation regions (30a, 30b),
and/or **in that** in step c) a first deformation profile (V) is distinguished from a second deformation profile (V), a first vehicle function being activated in accordance with step d) when the first deformation profile (V) is determined, and a second vehicle function being activated when the second deformation profile (V) is determined.

13. The method (100) according to any one of the preceding claims,
**characterized in that**
according to step c) at least one first detection signal (110a) and at least one second detection signal (110b), and preferably at least one third and fourth detection signal (110c, 110d), from different sensor elements (20) in each case are compared with one another in order to determine the deformation profile (V), the detection signals in each case comprising time-dependent information, so that a temporal deformation pattern is determined by the evaluation,
and/or **in that** the deformation profile (V) is specific to a mechanical gesture on a vehicle part (4), in particular the mechanical gesture leading to elastic deformation of the vehicle part (4) and/or movement of at least one activation means (31) relative to at least one of the sensor elements (20).

14. The method (100) according to any one of the preceding claims,
**characterized in that**
in step c) a speed of an execution and/or sequence of activation actions is determined on the basis of the detections and/or the deformation profile (V), the activation actions in each case comprising at least one deformation in at least one of the deformation regions (30a, 30b),
and/or **in that**, according to step c), an activation movement and/or sequence of activation actions in a first direction is distinguished from an activation movement and/or sequence of activation actions in a second direction on the basis of the evaluation, preferably a circular activation movement and/or sequence being distinguished from a linear activation movement and/or sequence in order to activate respectively associated different vehicle functions, the activation actions and/or the activation movements each comprising at least one deformation in at least one of the deformation regions (30a, 30b), and/or **in that** at least the evaluation according to step c) is carried out by a processing device (80), the processing device (80) providing an evaluation result of the evaluation of a vehicle electronic system, in particular via an electrical interface and/or interface device (40), the evaluation result preferably indicating the vehicle function to be activated.

15. The method (100) according to any one of the preceding claims,
**characterized in that**
the evaluation of the first and/or the at least second detection is carried out in such a way that at least one force influence is determined, which is correlated with at least one of the respective deformations,
and/or **in that** at least the evaluation according to step c) is carried out by a processing device (80), the processing device (80) being designed according to a sensor system (200) and/or sensor module (300) according to one of the preceding claims.

## Revendications

1. Système de détection (200) pour l'activation d'au moins une fonction de véhicule d'un véhicule (1), de préférence pour l'activation d'au moins une serrure électrique (3) du véhicule (1), présentant :
- au moins un premier et un deuxième élément de détection (20a, 20b) respectivement pour détecter une déformation dans au moins une zone de déformation (30a, 30b) sur le véhicule (1),
- au moins un dispositif de traitement (80) pour évaluer la détection respective des éléments de détection (20a, 20b),
**caractérisé en ce qu'**
une courbe de déformation (V) détectée par les éléments de détection (20a, 20b) peut être exploitée par le dispositif de traitement (80), de sorte que l'au moins une fonction du véhicule peut être activée en fonction de la courbe de déformation (V) détectée,
dans lequel les au moins premier et deuxième éléments de détection (20a, 20b) sont respectivement réalisés pour la mesure d'inductance, de sorte qu'un résultat de mesure de l'inductance est spécifique à la déformation dans une zone de déformation respective (30a, 30b) sur un revêtement extérieur (4) du véhicule (1), et
un agencement géométrique (93) d'au moins trois des éléments de détection (20) est prévu, au moins le premier élément de détection (20a) étant disposé à une distance (B) d'au moins un capteur par rapport au deuxième élément de détection (20b) et aux autres éléments de détection (20), de sorte que la courbe de déformation (V) peut être détectée en fonction de l'agencement géométrique (93).

2. Système de détection (200) selon la revendication 1,
**caractérisé en ce que**
l'au moins une zone de déformation (30) comprend respectivement une zone d'une partie de véhicule (4), en particulier d'un revêtement extérieur (4) du véhicule (1), en particulier à l'extérieur d'une poignée de porte (10).

3. Système de détection (200) selon l'une des revendications précédentes,
**caractérisé en ce qu'**
un agencement géométrique (93) d'au moins quatre ou cinq des éléments de détection (20) est prévu, au moins le premier élément de détection (20a) étant de préférence disposé à distance du deuxième élément de détection (20b) et/ou des autres éléments de détection (20) avec au moins une distance de capteur (B), de sorte que la courbe de déformation (V) peut être détectée en fonction de l'agencement géométrique (93),
et/ou **en ce qu'**au moins un premier et un deuxième élément de détection (20a, 20b), et en particulier d'autres éléments de détection (20), sont disposés dans un agencement géométrique (93) avec des distances de capteur (B) fixes entre eux, et sont de préférence reliés fixement entre eux par un boîtier (90), et sont notamment disposés au moins partiellement selon l'agencement géométrique (93) en forme de cercle ou de rectangle ou de polygone ou de losange ou de rangée ou de trapèze ou de carré ou d'ellipse ou de losange ou d'étoile ou de croix.

4. Système de détection (200) selon l'une des revendications précédentes,
**caractérisé en ce que**
les éléments de détection (20) sont réalisés chacun comme élément de détection LDC, en particulier comme bobine LDC, de sorte que le système de détection (200) est réalisé comme un système de détection LDC.

5. Système de détection (200) selon l'une des revendications précédentes,
**caractérisé en ce qu'**
il est prévu un boîtier (90), en particulier pour recevoir et/ou disposer au moins partiellement les éléments de détection (20) et/ou le dispositif de traitement (80) et/ou une carte de circuit imprimé (81), la carte de circuit imprimé (81) étant de préférence surmoulée dans le boîtier (90) et/ou coulée avec une masse de scellement (94), le boîtier (90) présentant de préférence une structure de fixation (91) pour fixer au moins les éléments de détection (20) sur une partie de véhicule (4), de préférence un revêtement extérieur (4) du véhicule (1),
et/ou **en ce qu'**il est prévu un boîtier (90) qui comprend au moins une entretoise (92), de sorte que, lors d'une fixation du boîtier (90) sur une partie de véhicule (4), les éléments de de détection (20) sont disposés chacun à distance d'un moyen d'activation (31) respectif, notamment inductif, dans la zone de déformation (30), de sorte que, de préférence, une déformation respective dans la zone de déformation (30) avec le moyen d'activation (31) respectif entraîne un mouvement relatif du moyen d'activation (31) respectif par rapport à l'élément de de détection (20) respectif espacé.

6. Système de détection (200) selon l'une des revendications précédentes,
**caractérisé en ce qu'**
un dispositif d'interface (40) est prévu pour transmettre un résultat de l'évaluation de la courbe de déformation (V) à une électronique de véhicule (6), en particulier centrale, le dispositif d'interface (40) étant de préférence réalisé pour être relié à un système de bus (7) du véhicule (1), de préférence en particulier à un bus LIN ou CAN ou à une installation à fréquence porteuse,
et/ou **en ce que** le système de détection (200) peut être relié par un dispositif d'interface (40) à un système de transmission (7), en particulier à une installation à fréquence porteuse (7), de sorte qu'aussi bien une alimentation en énergie pour le système de détection (200) qu'une transmission de données, en particulier entre le dispositif de traitement (80) et une électronique de véhicule (6), sont fournies par le système de transmission (7), en particulier par des conducteurs électriques identiques.

7. Système de détection (200) selon l'une des revendications précédentes,
**caractérisé en ce qu'**
une zone entre les éléments de détection (20) respectifs, et en particulier au moins un moyen d'activation (60) respectivement associé, est au moins partiellement remplie d'un élément de remplissage, en particulier d'une masse de scellement (94).

8. Module de détection (300) pour l'activation d'au moins une fonction de véhicule d'un véhicule (1), de préférence pour l'activation d'au moins une serrure électrique (3) du véhicule (1), avec au moins un premier et au moins un deuxième élément de détection (20a, 20b), et avec un boîtier (90), qui présente au moins une structure de fixation (91), **caractérisé en ce que**
les éléments de détection (20) sont reliés fixement les uns aux autres par l'intermédiaire de la structure de fixation (91) du boîtier (90), de sorte que les éléments de détection (20) forment un agencement géométrique (93), le module de détection (300) peut être fixé par la structure de fixation (91) à une partie (4) du véhicule (1) de telle sorte que l'agencement géométrique (93) corresponde à au moins une zone de déformation (30) sur la partie (4) du véhicule,
dans lequel les au moins premier et deuxième éléments de détection (20a, 20b) sont respectivement réalisés pour la mesure d'inductance, de sorte qu'un résultat de mesure de l'inductance est spécifique à la déformation dans une zone de déformation respective (30a, 30b) sur un revêtement extérieur (4) du véhicule (1), et
un agencement géométrique (93) d'au moins trois des éléments de détection (20) est prévu, au moins le premier élément de détection (20a) étant disposé à une distance (B) d'au moins un capteur par rapport au deuxième élément de détection (20b) et aux autres éléments de détection (20), de sorte que la courbe de déformation (V) peut être détectée en fonction de l'agencement géométrique (93).

9. Module de détection (300) selon l'une des revendications précédentes,
**caractérisé en ce que**
le module de détection (300) est réalisé sous la forme d'un module manipulable individuellement, de préférence pour la fixation sur un côté intérieur (5) de la partie de véhicule (4), de préférence un revêtement extérieur (4) et/ou une poignée de porte (10) du véhicule (1),
et/ou **en ce que** le module de détection (300) est réalisé selon un système de détection (200) selon l'une des revendications précédentes.

10. Véhicule (1), en particulier véhicule automobile (1),
avec au moins un système de détection (200) selon l'une des revendications précédentes et/ou avec au moins un module de détection (300) selon l'une des revendications précédentes,
**caractérisé en ce qu'**
un premier système de détection (200) et/ou un premier module de détection (300) est disposé sur une première zone du véhicule (1), en particulier dans une zone arrière du véhicule (1), et un deuxième système de détection (200) et/ou un deuxième module de détection (300) est disposé sur une deuxième zone du véhicule (1), en particulier dans une zone latérale du véhicule (1), de sorte que des courbes de déformation (V) peuvent être détectées sur les différentes zones du véhicule (1), afin d'activer en particulier respectivement différentes fonctions du véhicule,
et/ou **en ce que** les différentes fonctions du véhicule comprennent chacune une activation d'une serrure électrique (3) respective, notamment pour libérer et/ou ouvrir des parties mobiles (2) du véhicule (1) avec les parties respectives (4) du véhicule.

11. Procédé (100) pour activer au moins une fonction de véhicule d'un véhicule (1), de préférence pour activer au moins une serrure électrique (3) du véhicule (1), avec au moins un premier et au moins un deuxième élément de détection (20a, 20b),
**caractérisé par les étapes suivantes** :
a) réalisation d'une première détection par le premier élément de détection (20a), où la première détection est spécifique à une première déformation dans une première zone de déformation (30a) sur le véhicule (1),
b) réalisation d'au moins une deuxième détection par ledit au moins deuxième élément de détection (20b), ladite au moins deuxième détection étant spécifique à au moins une deuxième déformation dans au moins une deuxième zone de déformation (30b) sur le véhicule (1),
c) l'évaluation de la première et de la au moins deuxième détection, de sorte qu'au moins une courbe de déformation (V) est déterminée,
d) activer la au moins une fonction du véhicule à l'aide de la courbe de déformation déterminée (V),
dans lequel les au moins premier et deuxième éléments de détection (20a, 20b) sont respectivement réalisés pour la mesure d'inductance, de sorte qu'un résultat de mesure de l'inductance est spécifique à la déformation dans une zone de déformation respective (30a, 30b) sur un revêtement extérieur (4) du véhicule (1), et
un agencement géométrique (93) d'au moins trois des éléments de détection (20) est prévu, au moins le premier élément de détection (20a) étant disposé à une distance (B) d'au moins un capteur par rapport au deuxième élément de détection (20b) et aux autres éléments de détection (20), de sorte que la courbe de déformation (V) peut être détectée en fonction de l'agencement géométrique (93).

12. Procédé (100) selon l'une quelconque des revendications précédentes,
**caractérisé en ce que**
l'évaluation selon l'étape c) comprend une comparaison de la première détection avec la au moins deuxième détection, de sorte que le courbe de déformation (V) est spécifique à un geste d'un utilisateur (18) du véhicule (1) dans les zones de déformation (30a, 30b), et/ou **en ce que**, à l'étape c), on distingue une première courbe de déformation (V) d'une deuxième courbe de déformation (V), une première fonction de véhicule étant activée selon l'étape d) lorsque la première courbe de déformation (V) est déterminée, et une deuxième fonction de véhicule étant activée lorsque la deuxième courbe de déformation (V) est déterminée.

13. Procédé (100) selon l'une quelconque des revendications précédentes,
**caractérisé en ce que**
selon l'étape c), pour déterminer la courbe de déformation (V), au moins un premier signal de détection (110a) et au moins un deuxième signal de détection (110b), et de préférence au moins un troisième et un quatrième signal de détection (110c, 110d), sont comparés entre eux par des éléments de détection (20) respectivement différents, les signaux de détection comprenant chacun une information dépendant du temps, de sorte que l'évaluation détermine un modèle de déformation dans le temps,
et/ou **en ce que** la courbe de déformation (V) est spécifique à un geste mécanique sur une partie de véhicule (4), le geste mécanique entraînant notamment la déformation élastique de la partie de véhicule (4) et/ou le déplacement d'au moins un moyen d'activation (31) par rapport à au moins l'un des éléments de détection (20).

14. Procédé (100) selon l'une quelconque des revendications précédentes,
**caractérisé en ce qu'**
à l'étape c), on détermine à l'aide des détections et/ou de la courbe de déformation (V) une vitesse d'exécution et/ou de succession d'actions d'activation, les actions d'activation comprenant chacune au moins une déformation dans au moins une des zones de déformation (30a, 30b),
et/ou **en ce que**, selon l'étape c), un mouvement d'activation et/ou une succession d'actions d'activation dans une première direction est distinguée d'un mouvement d'activation et/ou d'une succession d'actions d'activation dans une deuxième direction à l'aide de l'évaluation, un mouvement d'activation et/ou une succession circulaire étant de préférence distinguée d'un mouvement d'activation et/ou d'une succession linéaire, afin d'activer des fonctions de véhicule différentes respectivement associées, les actions d'activation et/ou les mouvements d'activation comprenant respectivement au moins une déformation dans au moins une des zones de déformation (30a, 30b),
et/ou **en ce qu'**au moins l'évaluation selon l'étape c) est effectuée par un dispositif de traitement (80), un résultat d'évaluation de l'évaluation d'une électronique de véhicule étant mis à disposition par le dispositif de traitement (80), en particulier par l'intermédiaire d'une interface électrique et/ou d'un dispositif d'interface (40), le résultat d'évaluation indiquant de préférence la fonction de véhicule à activer.

15. Procédé (100) selon l'une quelconque des revendications précédentes,
**caractérisé en ce que**
l'évaluation de la première et/ou de la au moins deuxième saisie s'effectue de telle sorte qu'au moins une influence de force est déterminée, laquelle est corrélée avec au moins une des déformations respectives,
et/ou **en ce qu'**au moins l'évaluation selon l'étape c) est effectuée par un dispositif de traitement (80), le dispositif de traitement (80) étant réalisé selon un système de détection(200) et/ou un module de détection (300) selon l'une des revendications précédentes.
